# EUROPEAN PATENT SPECIFICATION

(11) **EP 2 490 333 B1**
(45) Date of publication and mention of the grant of the patent: **04.09.2019**
(21) Application number: 10823385.9
(22) Date of filing: 12.10.2010
(51) Int. Cl.: H03H 9/25, H03H 9/145, H03H 9/02

(54) **SURFACE ACOUSTIC WAVE DEVICE**
AKUSTISCHES OBERFLÄCHENWELLENELEMENT
DISPOSITIF À ONDE DE SURFACE ÉLASTIQUE

(30) Priority: 13.10.2009 JP 2009236276
(43) Date of publication of application: 22.08.2012
(73) Proprietor: Murata Manufacturing Co., Ltd., Kyoto 617-8555 (JP)
(72) Inventor: KADOTA, Michio, Nagaokakyo-shi Kyoto 617-8555 (JP)
(74) Representative: Delumeau, François Guy
(86) International application number: PCT/JP2010/067887
(87) International publication number: WO 2011/046117

(56) References cited:
- WO-A1-2004/006431
- JP-A- 10 322 158
- JP-A- 11 031 942
- JP-A- H09 208 399
- JP-A- 2004 254 291
- JP-A- 2004 336 503
- JP-A- 2004 343 359
- JP-A- 2005 184 758
- JP-A- 2006 298 694
- JP-A- 2006 319 679
- US-A1- 2004 222 717
- US-B1- 6 259 186
- US-B1- 6 548 937
- KUZNETSOVA I ET AL: "Investigation of acoustic waves of higher order propagating in plates of lithium niobate", ULTRASONICS, IPC SCIENCE AND TECHNOLOGY PRESS LTD. GUILDFORD, GB, vol. 42, no. 1-9, 1 April 2004 (2004-04-01), pages 179-182, XP027331344, ISSN: 0041-624X [retrieved on 2004-03-21]

## Description

### Technical Field

The present invention relates to a surface acoustic wave device for use in, e.g., a resonator and a band filter, and more particularly to a surface acoustic wave device in which a piezoelectric substrate has a LiNbO₃ film.

### Background Art

Recently, a surface acoustic wave device adapted for a higher frequency has been demanded with a trend toward communication equipment operating in a higher frequency range. Also, a wider frequency band has been keenly demanded in a surface acoustic wave filter, etc.

The acoustic velocity of the surface acoustic wave and the electromechanical coupling coefficient k² are required to be higher or larger in order to realize a higher frequency and a wider frequency band in the operation.

Patent Literature (PTL) 1, given below, discloses a surface acoustic wave device using a piezoelectric substrate in which a (100) LiNbO₃ thin film is formed on a (012) sapphire substrate. PTL 1 states that the electromechanical coupling coefficient can be increased by forming the (100) LiNbO₃ thin film on the (012) sapphire substrate.

Meanwhile, PTL 2, given below, discloses a surface acoustic wave device illustrated in Fig. 62. In this surface acoustic wave device 1001, a LiNbO₃ single-crystal layer 1003 is formed, instead of being a thin film, on a diamond substrate 1002. An IDT electrode 1004 is formed on the LiNbO₃ single-crystal layer 1003. In such a structure, given that the thickness of the LiNbO₃ single-crystal layer 1003 is t₁ (µm) and the wavelength of a surface acoustic wave in the n-th order mode is λn (µm), kh₁ = 2π(t₁/λn) and the Euler angles of the LiNbO₃ single-crystal layer 1003 are set to fall within respective specific ranges. PTL 2 states that, when those conditions are satisfied, the propagation velocity of the surface acoustic wave can be increased and the electromechanical coupling coefficient k² can also be increased.

### Citation List

### Patent Literature

PTL 1: Japanese Unexamined Patent Application Publication No. 10-322158
PTL2: Japanese Unexamined Patent Application Publication No. 9-219632

JP 2006 319679 describes a surface acoustic wave device in which a piezoelectric substrate, such as an LiNbO₃ substrate 5-100µm thick is bonded to a support substrate such as a Si substrate. The LiNbO₃ substrate may be a 0°-70° rotated Y-cut LiNbO₃ substrate.

### Summary of Invention

### Technical Problem

In the surface acoustic wave device disclosed in PTL 1, the piezoelectric substrate including (100) LiNbO₃ thin film stacked on the (012) sapphire substrate is used, but the range of Euler angles of the LiNbO₃ thin film where the electromechanical coupling coefficient can be increased is limited to a narrow range.

On the other hand, the surface acoustic wave device disclosed in PTL 2 has the structure where the LiNbO₃ single-crystal layer 1003 is stacked, instead of being a thin film, on the diamond substrate 1002, with intent to increase the acoustic velocity of the surface acoustic wave and the electromechanical coupling coefficient. However, the diamond substrate 1002 made of single-crystal diamond is expensive and a cost reduction is keenly demanded.

In view of the above-described current state of the related art, an object of the present invention is to provide a surface acoustic wave device, which can increase the acoustic velocity of the surface acoustic wave and the electromechanical coupling coefficient by using LiNbO₃ having a wider range of Euler angles, and which is inexpensive.

### Solution to Problem

The present invention provides a surface acoustic wave device comprising a piezoelectric substrate including a high acoustic-velocity substrate in which an acoustic velocity of a transverse wave is 5400 m/sec or higher and 8660 m/sec or lower, and a LiNbO₃ single-crystal plate formed on the high acoustic-velocity substrate and having Euler angles (0°, 67° to 160°, -5° to +5°); and an electrode formed on the piezoelectric substrate and made of metal. The thickness of the LiNbO₃ single-crystal plate is in the range of 0.05λ to 1.6λ

Thus, the acoustic velocity of a surface acoustic wave can be raised and the electromechanical coupling coefficient k² can be increased by using the piezoelectric substrate in which the LiNbO₃ single-crystal plate having the above-mentioned specific crystal orientation and relative thickness is stacked on the above-mentioned specific high acoustic-velocity substrate.

A thickness of the LiNbO₃ single-crystal plate is more preferably in the range of 0.15λ to 1.6λ when a wavelength of a surface acoustic wave is defined as λ. In this case, a larger electromechanical coupling coefficient k² can be obtained.

The high acoustic-velocity substrate is not limited to a particular one. For example, the high acoustic-velocity substrate is provided as a substrate made of a material selected from a group consisting of silicon carbide, alumina, aluminum nitride, sapphire, silicon nitride, silicon, and magnesium oxide.

In the present invention, the Euler angles of the LiNbO₃ single-crystal plate are in a range of (0°, 92° to 132°, -5° to +5°). In this case, an even larger electromechanical coupling coefficient k² can be obtained.

In the present invention, preferably, a first order mode of a surface acoustic wave is used as the surface acoustic wave. In this case, the acoustic velocity can be raised and a large electromechanical coupling coefficient k² can be obtained.

With another specific aspect of the present invention, the high acoustic-velocity substrate is made of SiC, and the Euler angles of the LiNbO₃ single-crystal plate are in a range of (0°, 70° to 160°, -5° to +5°). In this case, the acoustic velocity can be further raised and a larger electromechanical coupling coefficient k² can be obtained.

With still another specific aspect of the surface acoustic wave device according to the present invention, the high acoustic-velocity substrate is made of alumina, and the Euler angles of the LiNbO₃ single-crystal plate are in a range of (0°, 70° to 160°, -5° to +5°).

With still another specific aspect of the surface acoustic wave device according to the present invention, the high acoustic-velocity substrate is made of aluminum nitride, and the Euler angles of the LiNbO₃ single-crystal plate are in a range of (0°, 70° to 153°, -5° to +5°).

With still another specific aspect of the surface acoustic wave device according to the present invention, the high acoustic-velocity substrate is made of sapphire, and the Euler angles of the LiNbO₃ single-crystal plate are in a range of (0°, 67° to 147°, -5° to +5°).

With still another specific aspect of the surface acoustic wave device according to the present invention, the high acoustic-velocity substrate is made of silicon nitride, and the Euler angles of the LiNbO₃ single-crystal plate are in a range of (0°, 70° to 153°, -5° to +5°).

In the surface acoustic wave device according to the present invention, preferably, the high acoustic-velocity substrate is made of silicon. In this case, the silicon may be made of a silicon single-crystal or a silicon polycrystal. When the silicon is made of a silicon single-crystal, the Euler angles of the LiNbO₃ single-crystal plate are preferably in a range of (0°, 75° to 152°, -5° to +5°). On that condition, the acoustic velocity can be further raised and a large electromechanical coupling coefficient k² can be obtained.

Further, when the silicon is made of a silicon polycrystal, the Euler angles of the LiNbO₃ single-crystal plate are preferably in a range of (0°, 75° to 148°, -5° to +5°). On that condition, the acoustic velocity can be further raised and an even larger electromechanical coupling coefficient k² can be obtained.

With another specific aspect of the surface acoustic wave device according to the present invention, the surface acoustic wave device further comprises a silicon oxide film stacked between the high acoustic-velocity substrate and the LiNbO₃ single-crystal plate, the silicon oxide film having a thickness in a range of 0.05λ to 1.4λ. In this case, an absolute value of the temperature coefficient of resonance frequency TCF can be reduced, and a temperature characteristic can be stabilized. In this case, preferably, when the high acoustic-velocity substrate is made of silicon, an absolute value of the temperature coefficient of resonance frequency TCF can be further reduced.

Moreover, when the high acoustic-velocity substrate is made of silicon in the structure in which the silicon oxide film is stacked between the high acoustic-velocity substrate and the LiNbO₃ single-crystal plate, the high acoustic-velocity substrate may be made of a silicon single-crystal or a silicon polycrystal.

### Advantageous Effects of Invention

With the surface acoustic wave device according to the present invention, since the high acoustic-velocity substrate is used in which an acoustic velocity of a transverse wave is 5400 m/sec or higher and 8660 m/sec or lower, the acoustic velocity of the surface acoustic wave can be raised. Further, the high acoustic-velocity substrate is inexpensive unlike the case using diamond. In addition, since the LiNbO₃ single-crystal plate is formed on the high acoustic-velocity substrate and has the Euler angles in the range of (0°, 67° to 160°, -5° to +5°), it is possible to not only raise the acoustic velocity of the surface acoustic wave by using the high acoustic-velocity substrate, but also to obtain a large electromechanical coupling coefficient k².

### Brief Description of Drawings

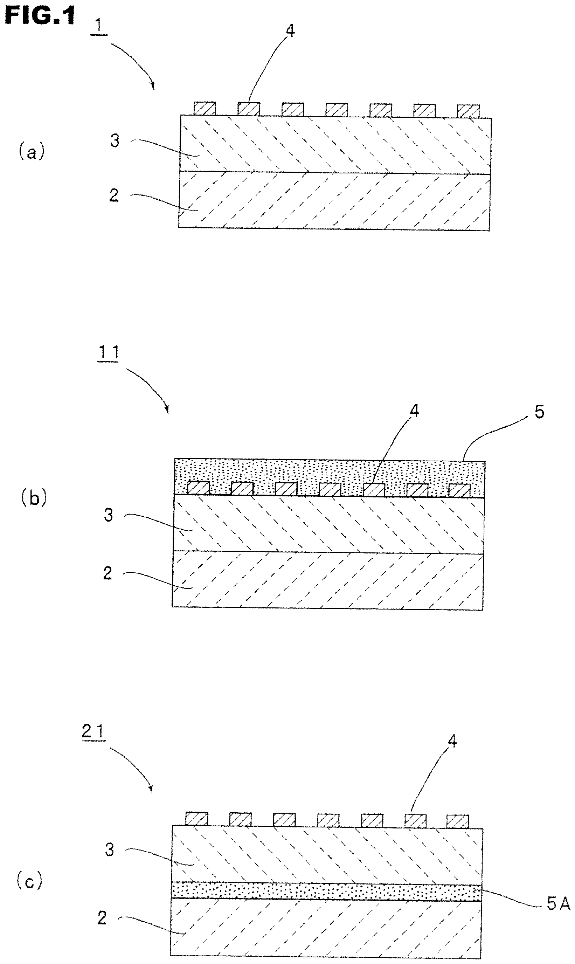

Fig. 1(a) is a sectional view illustrating a surface acoustic wave device according to a first embodiment of the present invention, and Figs. 1(b) and 1(c) are front sectional views illustrating surface acoustic wave devices according to second and third embodiments of the present invention, respectively.

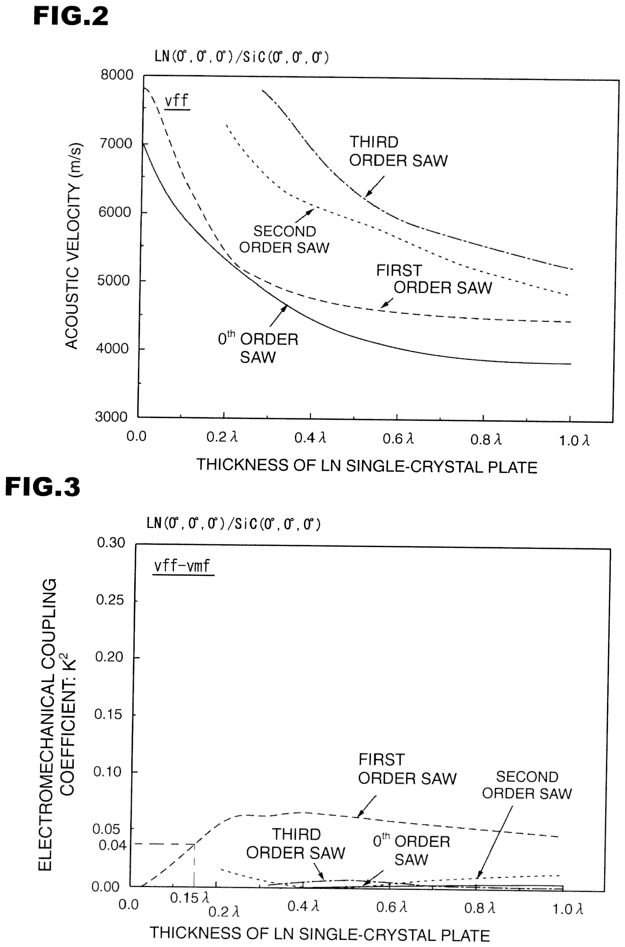

Fig. 2 is a graph depicting, in a structure where a LiNbO₃ single-crystal plate having the Euler angles (0°, 0°, 0°) is stacked on a SiC substrate having the Euler angles (0°, 0°, 0°), the relationship between the thickness of the LiNbO₃ single-crystal plate and the acoustic velocity of a surface acoustic wave.
Fig. 3 is a graph depicting, in the structure where the LiNbO₃ single-crystal plate having the Euler angles (0°, 0°, 0°) is stacked on the SiC substrate having the Euler angles (0°, 0°, 0°), the relationship between the thickness of the LiNbO₃ single-crystal plate and the electromechanical coupling coefficient k².

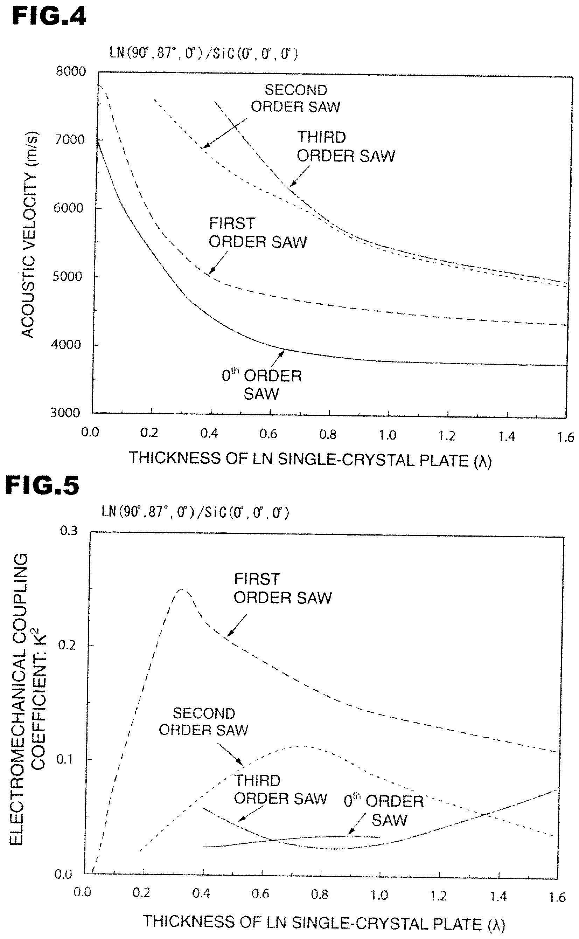

Fig. 4 is a graph depicting, in a structure where a LiNbO₃ single-crystal plate having the Euler angles (90°, 87°, 0°) is stacked on the SiC substrate having the Euler angles (0°, 0°, 0°), the relationship between the thickness of the LiNbO₃ single-crystal plate and the acoustic velocity of a surface acoustic wave.
Fig. 5 is a graph depicting, in the structure where the LiNbO₃ single-crystal plate having the Euler angles (90°, 87°, 0°) is stacked on the SiC substrate having the Euler angles (0°, 0°, 0°), the relationship between the thickness of the LiNbO₃ single-crystal plate and the electromechanical coupling coefficient k².

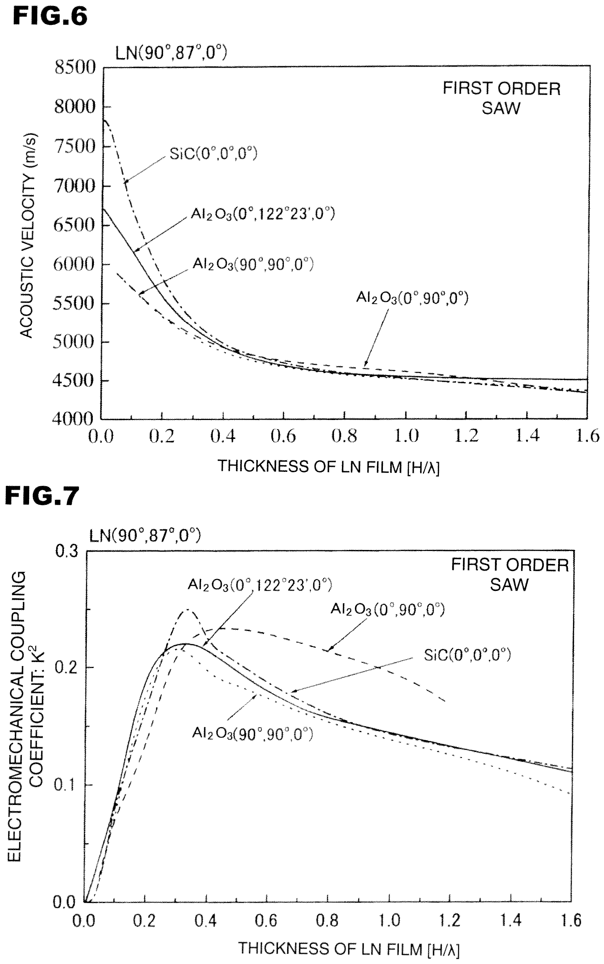

Fig. 6 is a graph depicting, in the cases using structures that the LiNbO₃ single-crystal plate having the Euler angles (90°, 87°, 0°) is stacked on each of substrates made of Al₂O₃, i.e., R-plane sapphire having the Euler angles (0°, 122°23', 0°), made of Al₂O₃, i.e., sapphire having the Euler angles (0°, 90°, 0°), and made of Al₂O₃, i.e., sapphire having the Euler angles (90°, 90°, 0°), the relationship between the thickness of the LiNbO₃ single-crystal plate and the acoustic velocity of a surface acoustic wave.
Fig. 7 is a graph depicting, in the cases using the structures that the LiNbO₃ single-crystal plate having the Euler angles (90°, 87°, 0°) is stacked on each of the substrates made of Al₂O₃, i.e., R-plane sapphire having the Euler angles (0°, 122°23', 0°), made of Al₂O₃, i.e., sapphire, having the Euler angles (0°, 90°, 0°), and made of Al₂O₃, i.e., sapphire having the Euler angles (90°, 90°, 0°), the relationship between the thickness of the LiNbO₃ single-crystal plate and the electromechanical coupling coefficient k² for a surface acoustic wave.

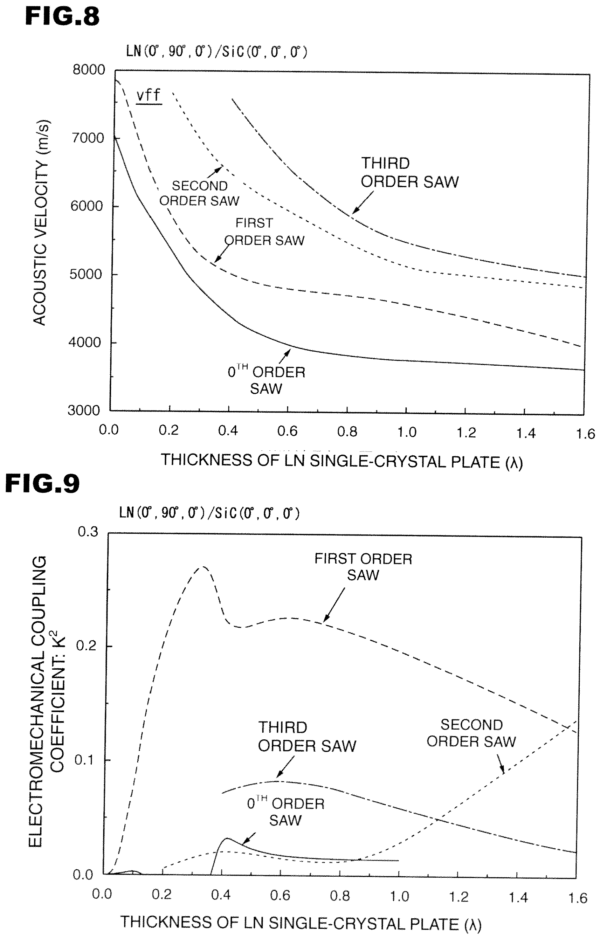

Fig. 8 is a graph depicting, in a structure where a LiNbO₃ single-crystal plate having the Euler angles (0°, 90°, 0°) is stacked on the SiC substrate having the Euler angles (0°, 0°, 0°), the relationship between the thickness of the LiNbO₃ single-crystal plate and the acoustic velocity of a surface acoustic wave.
Fig. 9 is a graph depicting, in the structure where the LiNbO₃ single-crystal plate having the Euler angles (0°, 90°, 0°) is stacked on the SiC substrate having the Euler angles (0°, 0°, 0°), the relationship between the thickness of the LiNbO₃ single-crystal plate and the electromechanical coupling coefficient k².

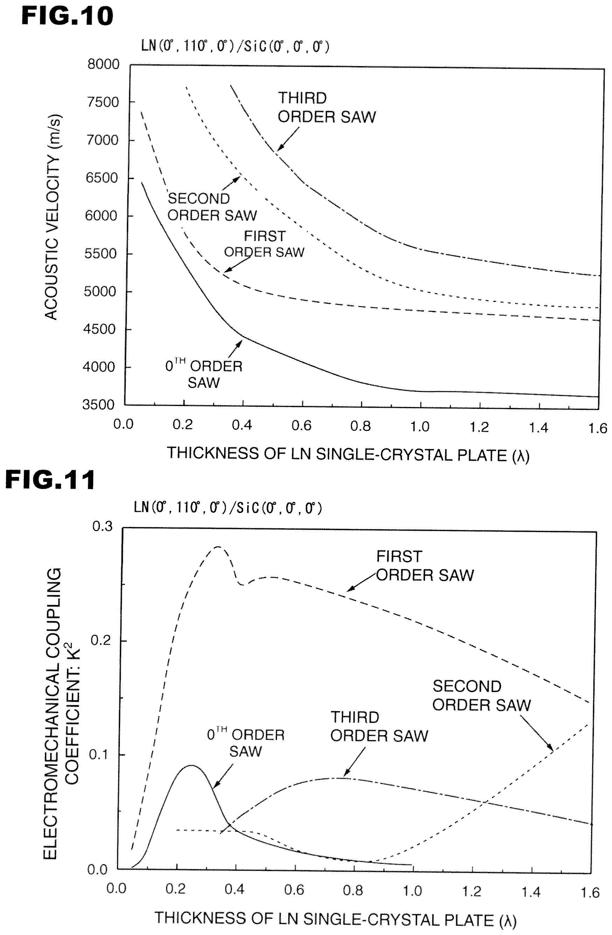

Fig. 10 is a graph depicting, in a structure where a LiNbO₃ single-crystal plate having the Euler angles (0°, 110°, 0°) is stacked on the SiC substrate having the Euler angles (0°, 0°, 0°), the relationship between the thickness of the LiNbO₃ single-crystal plate and the acoustic velocity of a surface acoustic wave.
Fig. 11 is a graph depicting, in the structure where the LiNbO₃ single-crystal plate having the Euler angles (0°, 110°, 0°) is stacked on the SiC substrate having the Euler angles (0°, 0°, 0°), the relationship between the thickness of the LiNbO₃ single-crystal plate and the electromechanical coupling coefficient k².

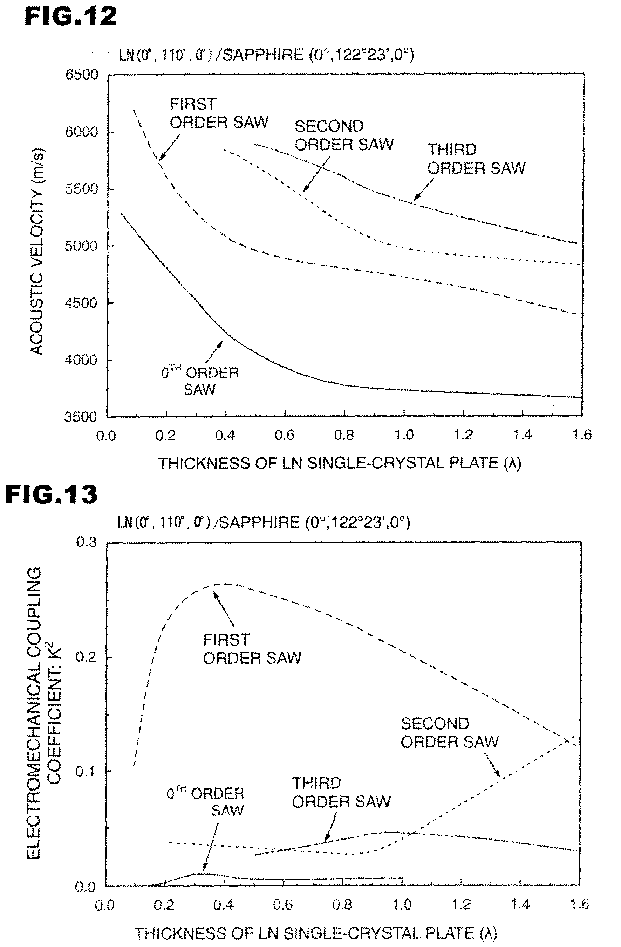

Fig. 12 is a graph depicting, in a structure where the LiNbO₃ single-crystal plate having the Euler angles (0°, 110°, 0°) is stacked on the R-plane sapphire having the Euler angles (0°, 122°23', 0°), the relationship between the thickness of the LiNbO₃ single-crystal plate and the acoustic velocity of a surface acoustic wave.
Fig. 13 is a graph depicting, in the structure where the LiNbO₃ single-crystal plate having the Euler angles (0°, 110°, 0°) is stacked on the R-plane sapphire having the Euler angles (0°, 122°23', 0°), the relationship between the thickness of the LiNbO₃ single-crystal plate and the electromechanical coupling coefficient k².

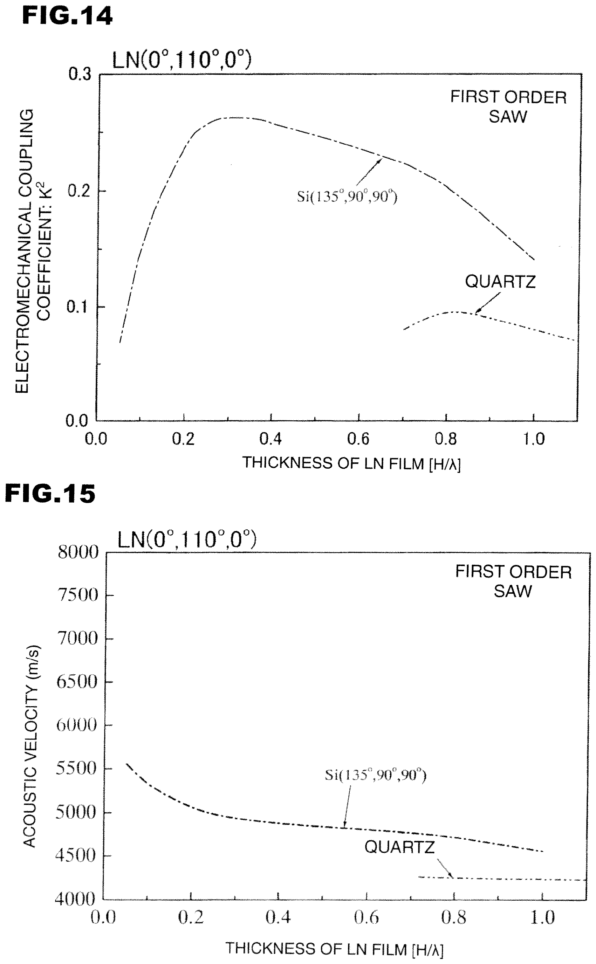

Fig. 14 is a graph depicting, when the LiNbO₃ single-crystal plate having the Euler angles (0°, 110°, 0°) is stacked on each of substrates made of a silicon single-crystal having the Euler angles (135°, 90°, 90°) and quartz, the relationship between the thickness of the LN single-crystal plate and the electromechanical coupling coefficient k².
Fig. 15 is a graph depicting, when the LiNbO₃ single-crystal plate having the Euler angles (0°, 110°, 0°) is stacked on each of substrates made of the silicon single-crystal having the Euler angles (135°, 90°, 90°) and quartz, the relationship between the thickness of the LN single-crystal plate and the acoustic velocity of a surface acoustic wave .

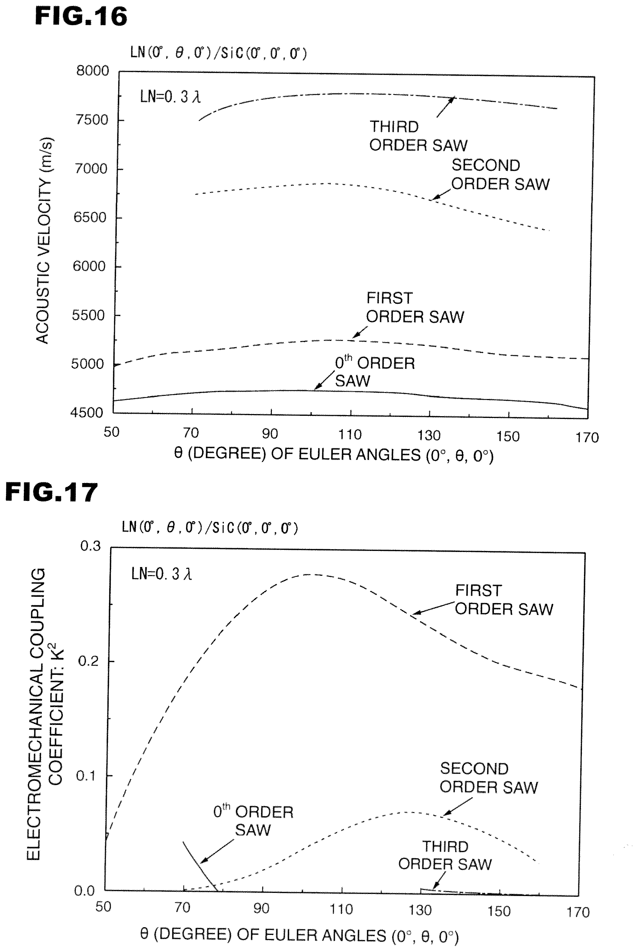

Fig. 16 is a graph depicting, in a structure where a LiNbO₃ single-crystal plate having the Euler angles (0°, θ, 0°) and a thickness of 0.3λ is stacked on the SiC substrate having the Euler angles (0°, 0°, 0°), the relationship between the Euler angle θ and the acoustic velocity of a surface acoustic wave.
Fig. 17 is a graph depicting, in the structure where the LiNbO₃ single-crystal plate having the Euler angles (0°, θ, 0°) and the thickness of 0.3λ is stacked on the SiC substrate having the Euler angles (0°, 0°, 0°), the relationship between the Euler angle θ and the electromechanical coupling coefficient k².

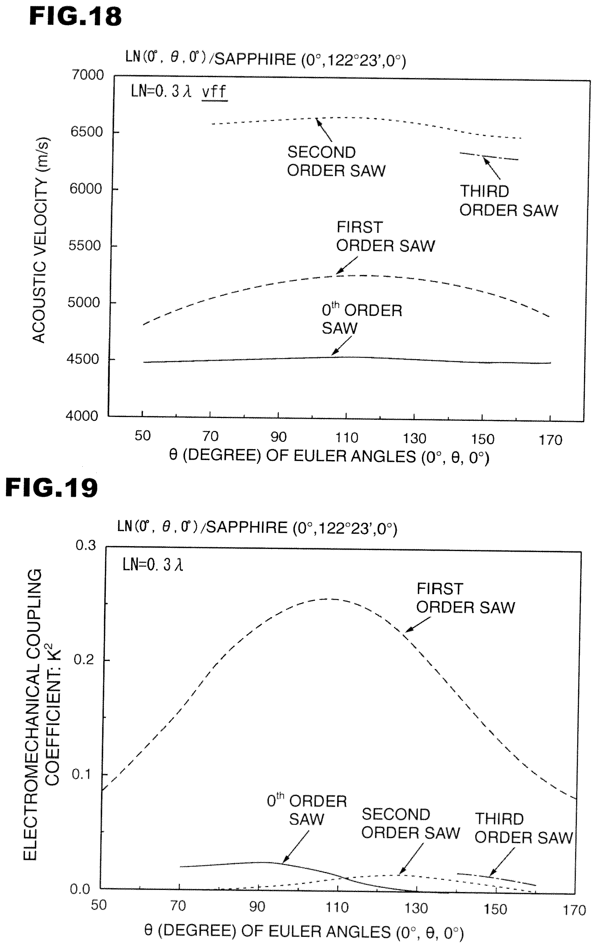

Fig. 18 is a graph depicting, in a structure where the LiNbO₃ single-crystal plate having the Euler angles (0°, θ, 0°) and the thickness of 0.3λ is stacked on a substrate made of R-plane sapphire having the Euler angles (0°, 122°23', 0°), the relationship between the Euler angle θ and the acoustic velocity of a surface acoustic wave.
Fig. 19 is a graph depicting, in the structure where the LiNbO₃ single-crystal plate having the Euler angles (0°, θ, 0°) and the thickness of 0.3λ is stacked on the substrate made of the R-plane sapphire having the Euler angles (0°, 122°23', 0°), the relationship between the Euler angle θ and the electromechanical coupling coefficient k².

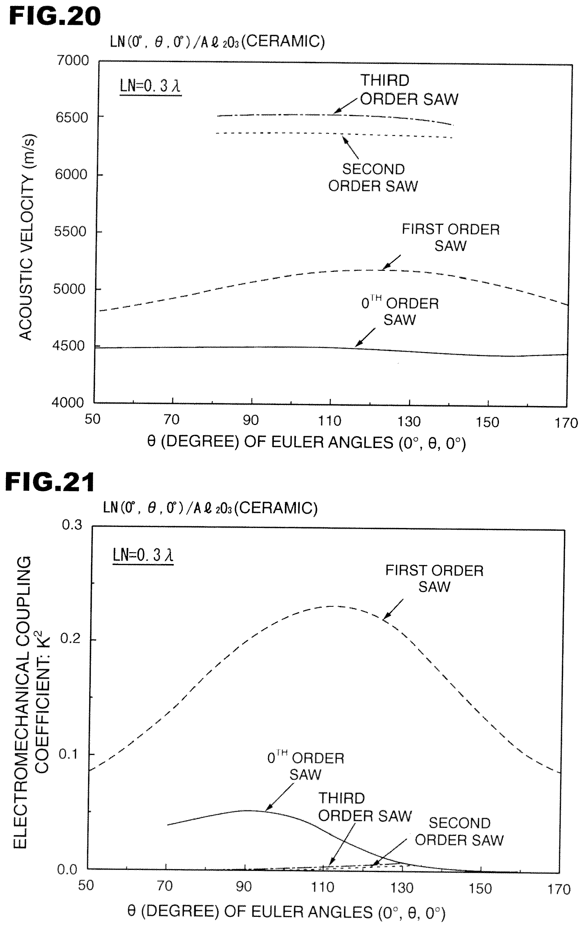

Fig. 20 is a graph depicting, in a structure where the LiNbO₃ single-crystal plate having the Euler angles (0°, θ, 0°) and the thickness of 0.3λ is stacked on a substrate made of alumina Al₂O₃, the relationship between the Euler angle θ and the acoustic velocity of a surface acoustic wave.
Fig. 21 is a graph depicting, in the structure where the LiNbO₃ single-crystal plate having the Euler angles (0°, θ, 0°) and the thickness of 0.3λ is stacked on the substrate made of alumina Al₂O₃, the relationship between the Euler angle θ and the electromechanical coupling coefficient k².

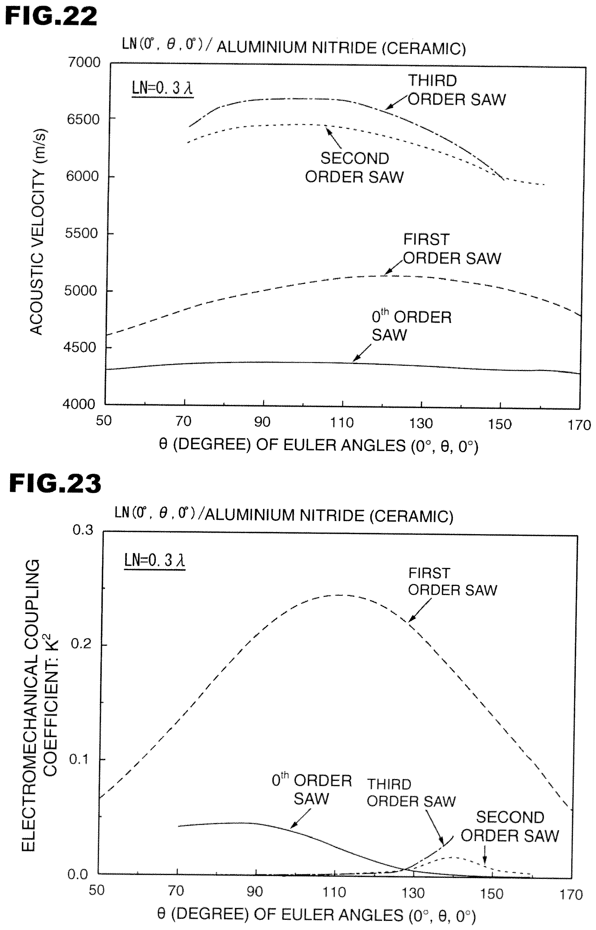

Fig. 22 is a graph depicting, in a structure where the LiNbO₃ single-crystal plate having the Euler angles (0°, θ, 0°) and the thickness of 0.3λ is stacked on a substrate made of aluminum nitride, the relationship between the Euler angle θ and the acoustic velocity of a surface acoustic wave.
Fig. 23 is a graph depicting, in the structure where the LiNbO₃ single-crystal plate having the Euler angles (0°, θ, 0°) and the thickness of 0.3λ is stacked on the substrate made of aluminum nitride, the relationship between the Euler angle θ and the electromechanical coupling coefficient k².

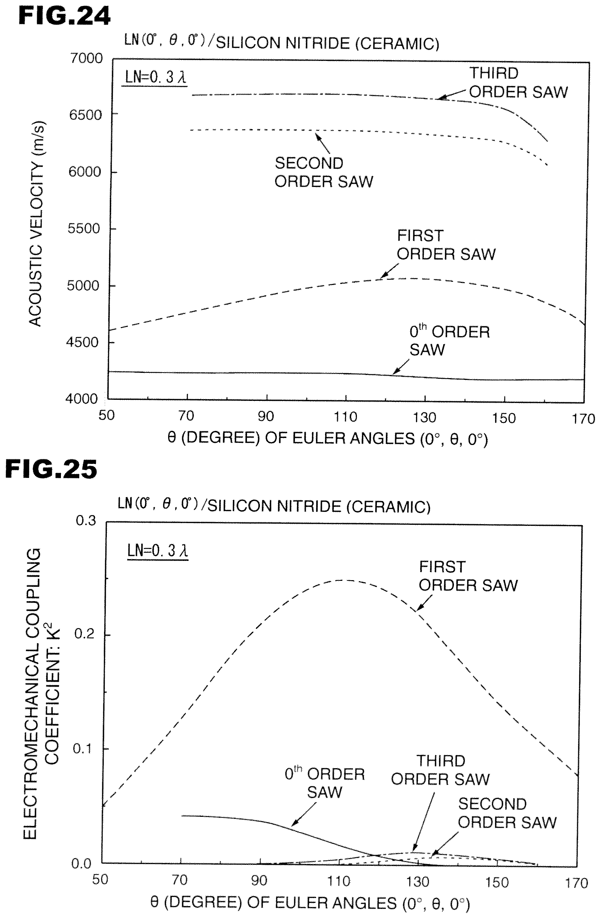

Fig. 24 is a graph depicting, in a structure where the LiNbO₃ single-crystal plate having the Euler angles (0°, θ, 0°) and the thickness of 0.3λ is stacked on a substrate made of silicon nitride, the relationship between the Euler angle θ and the acoustic velocity of a surface acoustic wave.
Fig. 25 is a graph depicting, in the structure where the LiNbO₃ single-crystal plate having the Euler angles (0°, θ, 0°) and the thickness of 0.3λ is stacked on the substrate made of silicon nitride, the relationship between the Euler angle θ and the electromechanical coupling coefficient k².

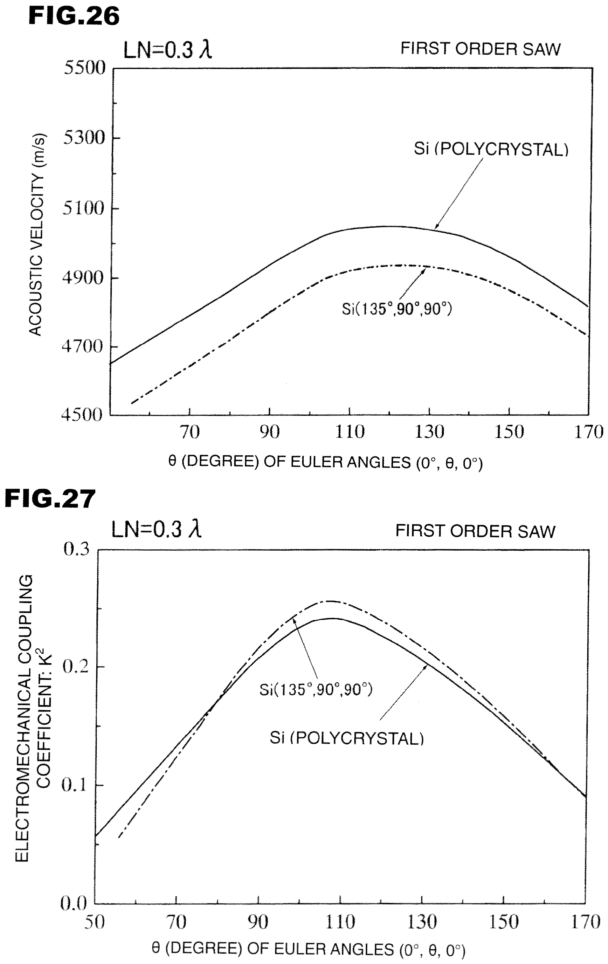

Fig. 26 is a graph depicting, when the LiNbO₃ single-crystal plate having the Euler angles (0°, θ°, 0°) is stacked on each of substrates made of the silicon single-crystal having the Euler angles (135°, 90°, 90°) and Si (polycrystal), the relationship between θ of the Euler angles (0°, θ°, 0°) and the acoustic velocity of a surface acoustic wave.
Fig. 27 is a graph depicting, when the LiNbO₃ single-crystal plate having the Euler angles (0°, θ°, 0°) is stacked on each of the substrates made of the silicon single-crystal having the Euler angles (135°, 90°, 90°) and Si (polycrystal), the relationship between θ of the Euler angles (0°, θ°, 0°) and the electromechanical coupling coefficient.

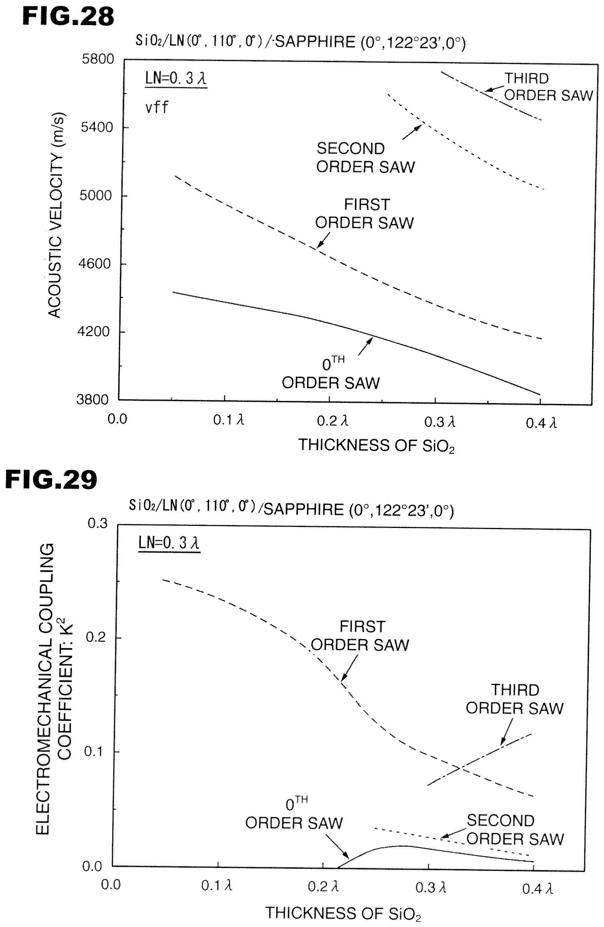

Fig. 28 is a graph depicting, in a structure of the surface acoustic wave device according to the second embodiment, illustrated in Fig. 1(b), where a LiNbO₃ single-crystal plate having the Euler angles (0°, 110°, 0°) and a thickness of 0.3λ and a SiO₂ film are stacked on a substrate made of R-plane sapphire having the Euler angles (0°, 122°23', 0°), the relationship between the thickness of the SiO₂ film and the acoustic velocity of a surface acoustic wave.
Fig. 29 is a graph depicting, in the structure of the surface acoustic wave device according to the second embodiment, illustrated in Fig. 1(b), where the LiNbO₃ single-crystal plate having the Euler angles (0°, 110°, 0°) and the thickness of 0.3λ and the SiO₂ film are stacked on the substrate made of the R-plane sapphire having the Euler angles (0°, 122°23', 0°), the relationship between the thickness of the SiO₂ film and the electromechanical coupling coefficient k².

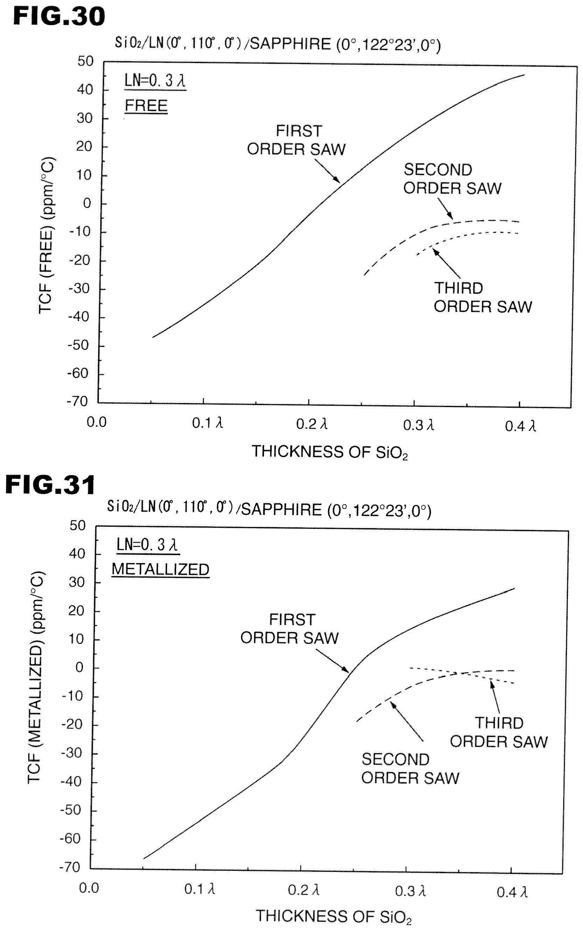

Fig. 30 is a graph depicting, in the structure of the surface acoustic wave device according to the second embodiment, illustrated in Fig. 1(b), where the LiNbO₃ single-crystal plate having the Euler angles (0°, 110°, 0°) and the thickness of 0.3λ and the SiO₂ film are stacked on the substrate made of the R-plane sapphire having the Euler angles (0°, 122°23', 0°), the relationship between the thickness of the SiO₂ film and the temperature coefficient of resonance frequency TCF in a free state.
Fig. 31 is a graph depicting, in the structure of the surface acoustic wave device according to the second embodiment, illustrated in Fig. 1(b), where the LiNbO₃ single-crystal plate having the Euler angles (0°, 110°, 0°) and the thickness of 0.3λ and the SiO₂ film are stacked on the substrate made of the R-plane sapphire having the Euler angles (0°, 122°23', 0°), the relationship between the thickness of the SiO₂ film and the temperature coefficient of resonance frequency TCF in a structure having a metallized surface.

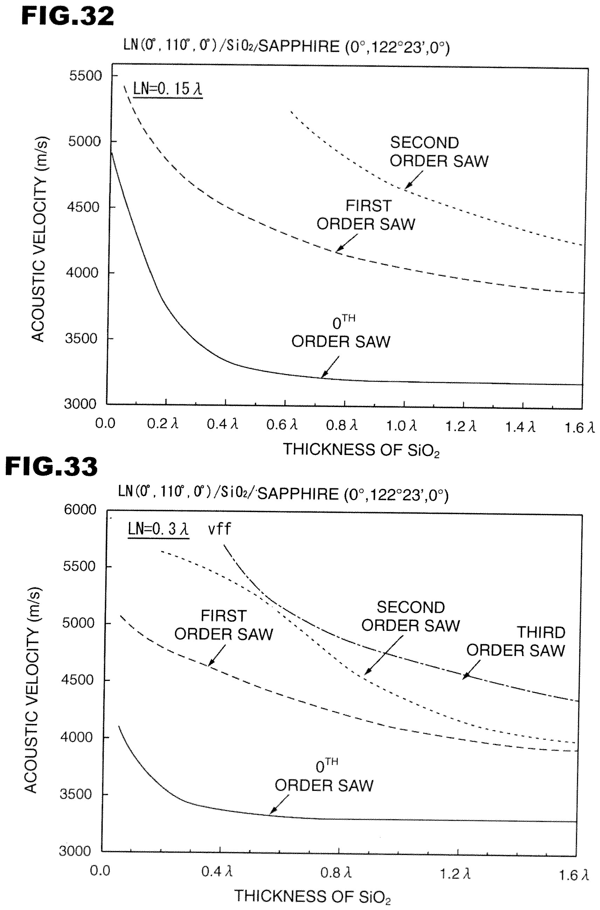

Fig. 32 is a graph depicting, in a structure of the surface acoustic wave device according to the third embodiment, illustrated in Fig. 1(c), where a SiO₂ film and a LiNbO₃ single-crystal plate having the Euler angles (0°, 110°, 0°) and a thickness of 0.15λ are stacked on the substrate made of the R-plane sapphire having the Euler angles (0°, 122°23', 0°), the relationship between the thickness of the SiO₂ film and the acoustic velocity of a surface acoustic wave.
Fig. 33 is a graph depicting, in a structure of the surface acoustic wave device according to the third embodiment, illustrated in Fig. 1(c), where a SiO₂ film and a LiNbO₃ single-crystal plate having the Euler angles (0°, 110°, 0°) and a thickness of 0.3λ are stacked on the R-plane sapphire having the Euler angles (0°, 122°23', 0°), the relationship between the thickness of the SiO₂ film and the acoustic velocity of a surface acoustic wave.

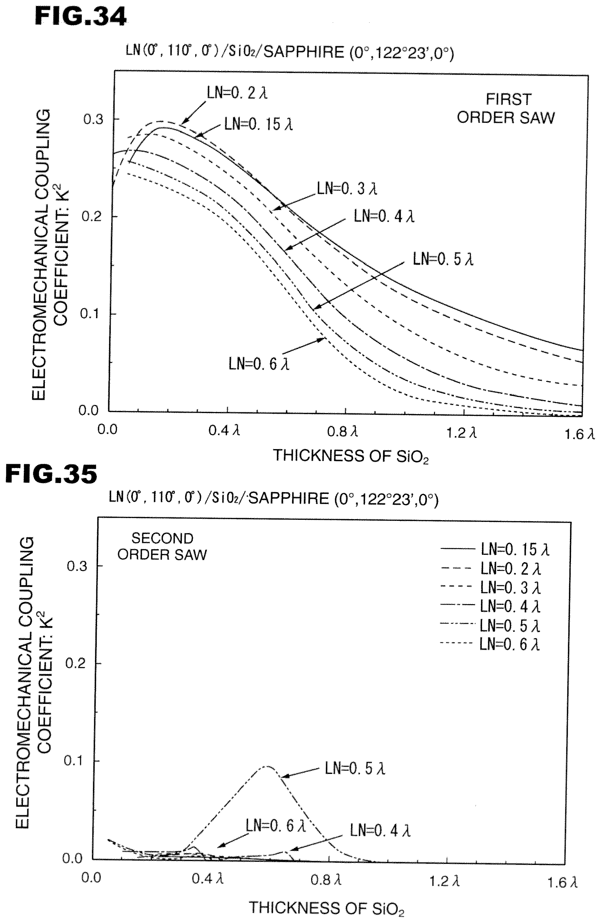

Fig. 34 is a graph depicting, in structures of the surface acoustic wave device according to the third embodiment, illustrated in Fig. 1(c), where a SiO₂ film and LiNbO₃ single-crystal plates having the Euler angles (0°, 110°, 0°) and various thicknesses are stacked on the substrate made of the R-plane sapphire having the Euler angles (0°, 122°23', 0°), the relationship among the thickness of each of the LiNbO₃ single-crystal plates, the thickness of the SiO₂ film, and the electromechanical coupling coefficient k² for a surface acoustic wave in the first order mode.
Fig. 35 is a graph depicting, in structures of the surface acoustic wave device according to the third embodiment, illustrated in Fig. 1(c), where a SiO₂ film and LiNbO₃ single-crystal plates having the Euler angles (0°, 110°, 0°) and thicknesses of 0.15λ to 0.6λ are stacked on the substrate made of the R-plane sapphire having the Euler angles (0°, 122°23', 0°), the relationship between the thickness of the SiO₂ film and the electromechanical coupling coefficient k² for a surface acoustic wave in the second order mode.

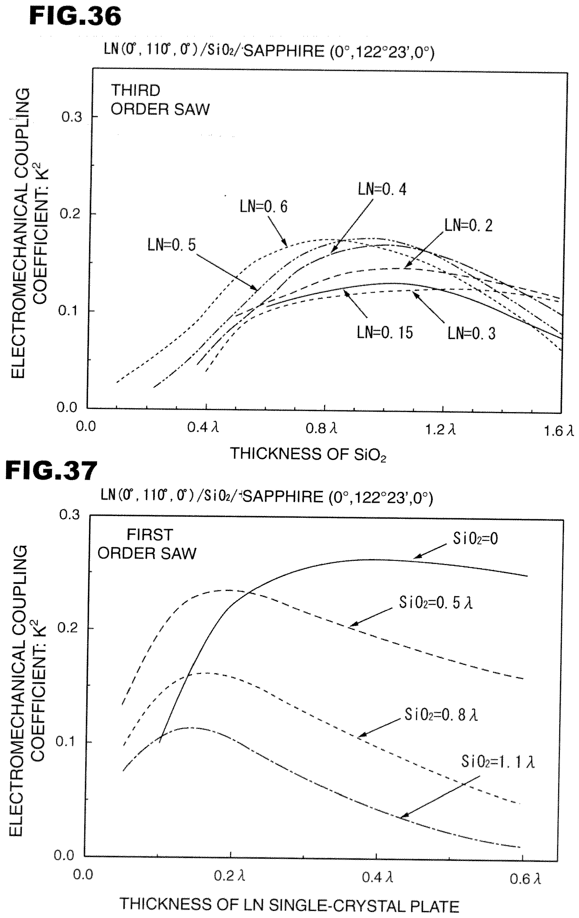

Fig. 36 is a graph depicting, in structures of the surface acoustic wave device according to the third embodiment, illustrated in Fig. 1(c), where a SiO₂ film and LiNbO₃ single-crystal plates having the Euler angles (0°, 110°, 0°) and various thicknesses are stacked on the substrate made of the R-plane sapphire having the Euler angles (0°, 122°23', 0°), the relationship among the thickness of each of the LiNbO₃ single-crystal plates, the thickness of the SiO₂ film, and the electromechanical coupling coefficient k² for a surface acoustic wave in the third order mode.
Fig. 37 is a graph depicting, in the structure of the surface acoustic wave device according to the third embodiment, illustrated in Fig. 1(c), where the SiO₂ film and the LiNbO₃ single-crystal plate having the Euler angles (0°, 110°, 0°) are stacked on the substrate made of the R-plane sapphire having the Euler angles (0°, 122°23', 0°), the relationship between the thickness of the LiNbO₃ single-crystal plate and the electromechanical coupling coefficient k² for a surface acoustic wave in the first order mode, when the thickness of the SiO₂ film is set to 0.5λ, 0.8λ or 1.1λ and when the SiO₂ film is not formed.

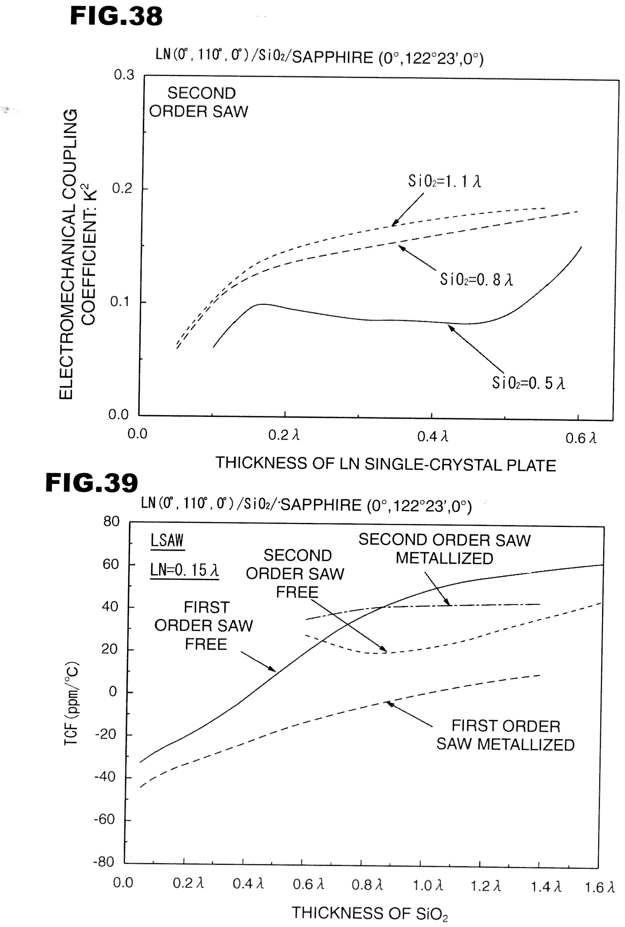

Fig. 38 is a graph depicting, in the structure of the surface acoustic wave device according to the third embodiment, illustrated in Fig. 1(c), where the SiO₂ film and the LiNbO₃ single-crystal plate having the Euler angles (0°, 110°, 0°) are stacked on the substrate made of the R-plane sapphire having the Euler angles (0°, 122°23', 0°), the relationship between the thickness of the LiNbO₃ single-crystal plate and the electromechanical coupling coefficient k² for a surface acoustic wave in the second order mode, when the thickness of the SiO₂ film is set to 0.5λ, 0.8λ or 1.1λ.
Fig. 39 is a graph depicting, in the structure where the SiO₂ film and the LiNbO₃ single-crystal plate having the Euler angles (0°, 110°, 0°) are stacked on the substrate made of the R-plane sapphire having the Euler angles (0°, 122°23', 0°), the relationship between the thickness of the SiO₂ film and the temperature coefficient of resonance frequency TCF, when the thickness of the LiNbO₃ single-crystal plate is set to 0.15λ and when a surface acoustic wave in the first order mode or the second order mode is utilized.

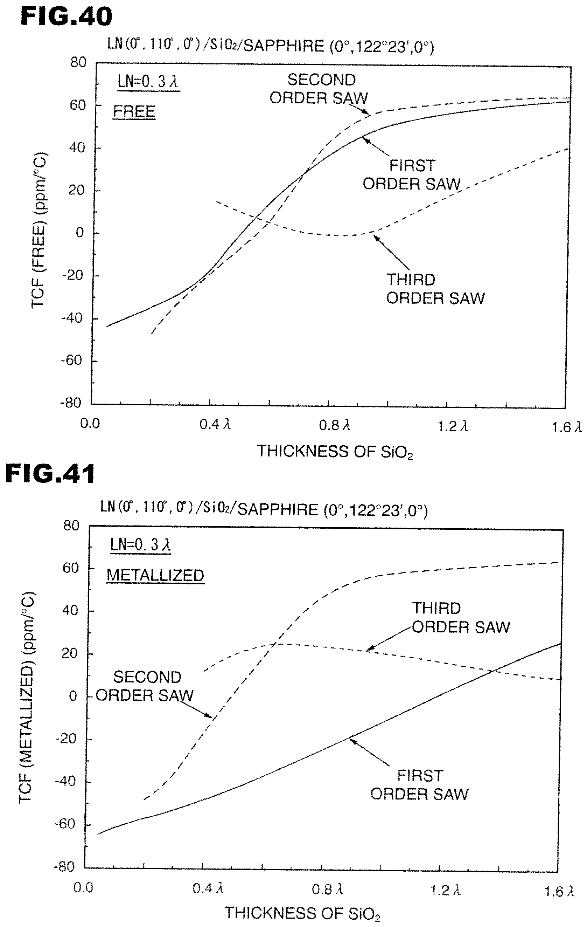

Fig. 40 is a graph depicting, in the structure where the SiO₂ film and the LiNbO₃ single-crystal plate having the Euler angles (0°, 110°, 0°) are stacked on the substrate made of the R-plane sapphire having the Euler angles (0°, 122°23', 0°), the relationship between the thickness of the SiO₂ film and the temperature coefficient of resonance frequency TCF (free) of a surface acoustic wave in the first order mode, the second order mode or the third order mode, when the thickness of the LiNbO₃ single-crystal plate is set to 0.3λ.
Fig. 41 is a graph depicting, in the structure where the SiO₂ film and the LiNbO₃ single-crystal plate having the Euler angles (0°, 110°, 0°) are stacked on the substrate made of the R-plane sapphire having the Euler angles (0°, 122°23', 0°), the relationship between the thickness of the SiO₂ film and the temperature coefficient of resonance frequency TCF (metallized) of a surface acoustic wave in the first order mode, the second order mode or the third order mode, when the thickness of the LiNbO₃ single-crystal plate is set to 0.3λ.

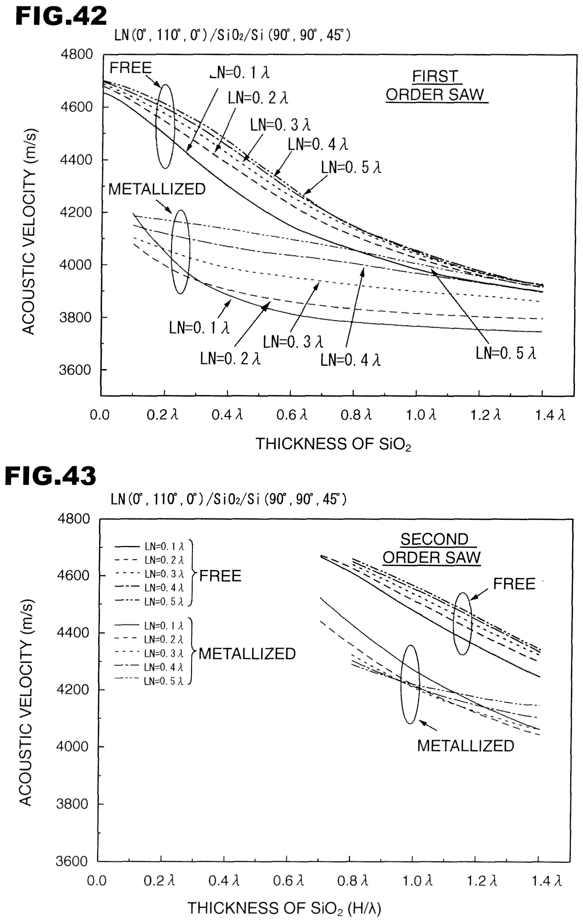

Fig. 42 is a graph depicting, in a structure of the surface acoustic wave device according to the third embodiment, illustrated in Fig. 1(c), where the SiO₂ film and the LiNbO₃ single-crystal plate having the Euler angles (0°, 110°, 0°) are stacked on a Si substrate made of Si (90°, 90°, 45°), the relationship among the thickness of the LiNbO₃ single-crystal plate, the thickness of the SiO₂ film, and the acoustic velocity of a surface acoustic wave in the first order mode.
Fig. 43 is a graph depicting, in the structure of the surface acoustic wave device according to the third embodiment, illustrated in Fig. 1(c), where the SiO₂ film and the LiNbO₃ single-crystal plate having the Euler angles (0°, 110°, 0°) are stacked on the Si substrate made of Si (90°, 90°, 45°), the relationship among the thickness of the LiNbO₃ single-crystal plate, the thickness of the SiO₂ film, and the acoustic velocity of a surface acoustic wave in the second order mode.

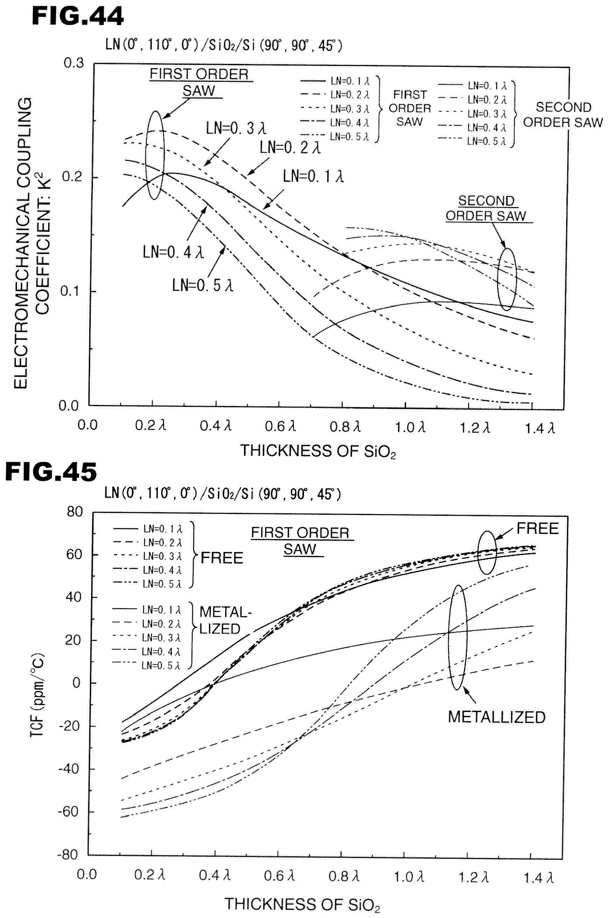

Fig. 44 is a graph depicting, in the structure of the surface acoustic wave device according to the third embodiment, illustrated in Fig. 1(c), where the SiO₂ film and the LiNbO₃ single-crystal plate having the Euler angles (0°, 110°, 0°) are stacked on the Si substrate made of Si (90°, 90°, 45°), the relationship among the thickness of the LiNbO₃ single-crystal plate, the thickness of the SiO₂ film, and the electromechanical coupling coefficients k² in the first order mode and the second order mode.
Fig. 45 is a graph depicting, in the structure of the surface acoustic wave device according to the third embodiment, illustrated in Fig. 1(c), where the SiO₂ film and the LiNbO₃ single-crystal plate having the Euler angles (0°, 110°, 0°) are stacked on the Si substrate made of Si (90°, 90°, 45°), the relationship among the thickness of the LiNbO₃ single-crystal plate, the thickness of the SiO₂ film, and the temperature coefficient of resonance frequency TCF of a surface acoustic wave in the first order mode.

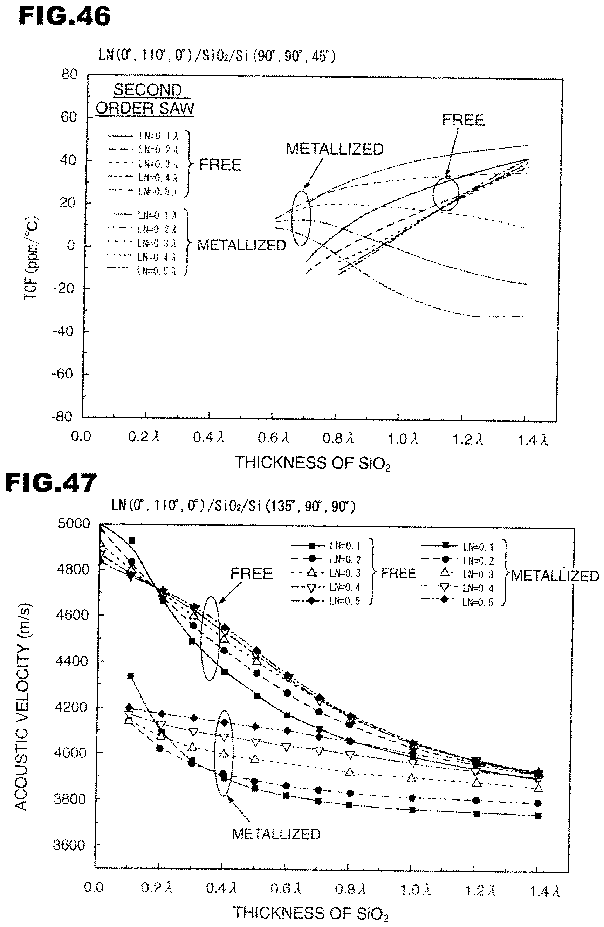

Fig. 46 is a graph depicting, in the structure of the surface acoustic wave device according to the third embodiment, illustrated in Fig. 1(c), where the SiO₂ film and the LiNbO₃ single-crystal plate having the Euler angles (0°, 110°, 0°) are stacked on the Si substrate having the Euler angles (90°, 90°, 45°), the relationship among the thickness of the LiNbO₃ single-crystal plate, the thickness of the SiO₂ film, and the temperature coefficient of resonance frequency TCF of a surface acoustic wave in the second order mode.
Fig. 47 is a graph depicting, in a structure of the surface acoustic wave device according to the third embodiment, illustrated in Fig. 1(c), where the SiO₂ film and the LiNbO₃ single-crystal plate having the Euler angles (0°, 110°, 0°) are stacked on a Si substrate having the Euler angles (135°, 90°, 90°), the relationship among the thickness of the LiNbO₃ single-crystal plate, the thickness of the SiO₂ film, and the acoustic velocity of a surface acoustic wave in the first order mode.

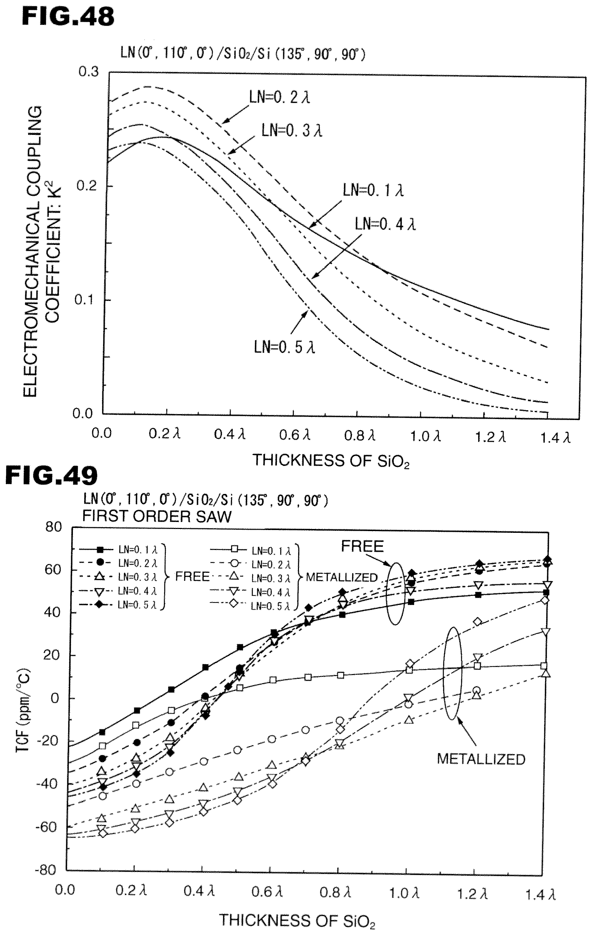

Fig. 48 is a graph depicting, in the structure of the surface acoustic wave device according to the third embodiment, illustrated in Fig. 1(c), where the SiO₂ film and the LiNbO₃ single-crystal plate having the Euler angles (0°, 110°, 0°) are stacked on the Si substrate having the Euler angles (135°, 90°, 90°), the relationship among the thickness of the LiNbO₃ single-crystal plate, the thickness of the SiO₂ film, and the electromechanical coupling coefficients k² for a surface acoustic wave in the first order mode.
Fig. 49 is a graph depicting, in the structure of the surface acoustic wave device according to the third embodiment, illustrated in Fig. 1(c), where the SiO₂ film and the LiNbO₃ single-crystal plate having the Euler angles (0°, 110°, 0°) are stacked on the Si substrate having the Euler angles (135°, 90°, 90°), the relationship among the thickness of the LiNbO₃ single-crystal plate, the thickness of the SiO₂ film, and the temperature coefficient of resonance frequency TCF of a surface acoustic wave in the first order mode.

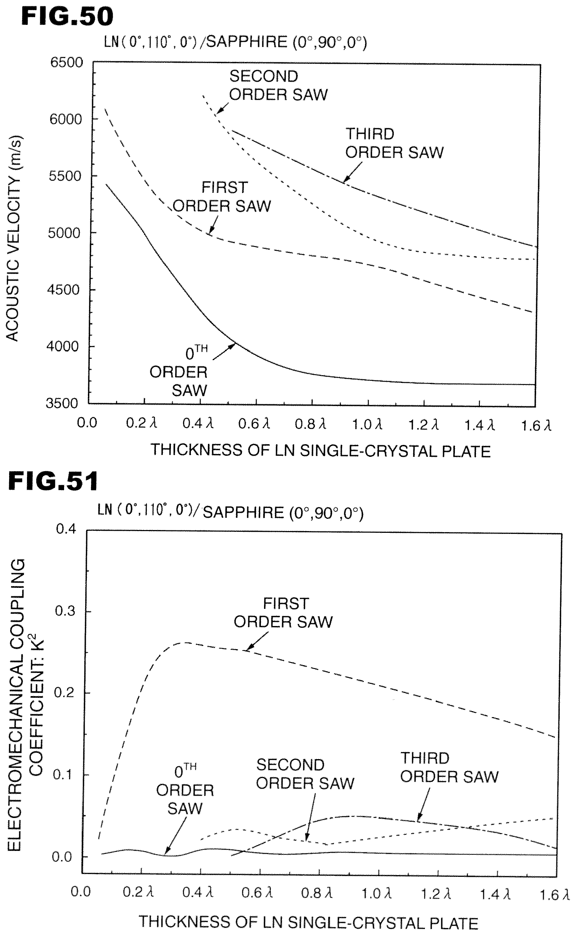

Fig. 50 is a graph depicting, in the surface acoustic wave device according to the first embodiment in which the LiNbO₃ single-crystal plate having the Euler angles (0°, 110°, 0°) is stacked on the sapphire substrate having the Euler angles (0°, 90°, 0°), the relationship between the acoustic velocity of a surface acoustic wave in each of the 0-th order mode, the first order mode, the second order mode and the third order mode and the thickness of the LiNbO₃ single-crystal plate.
Fig. 51 is a graph depicting, in the surface acoustic wave device according to the first embodiment in which the LiNbO₃ single-crystal plates having the Euler angles (0°, 110°, 0°) is stacked on the sapphire substrate having the Euler angles (0°, 90°, 0°), the relationship between the electromechanical coupling coefficient k² in each of the 0-th order mode, the first order mode, the second order mode and the third order mode and the thickness of the LiNbO₃ single-crystal plate.

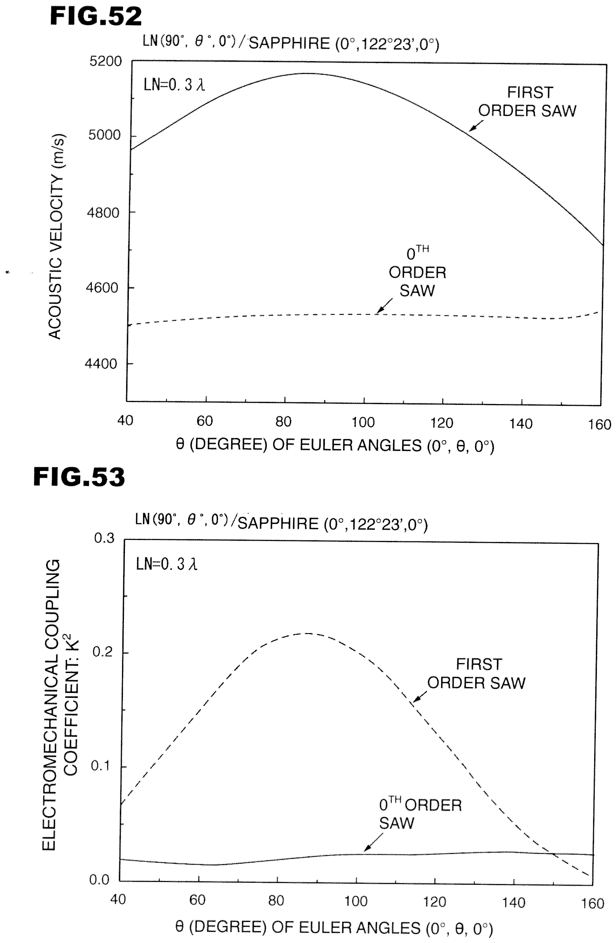

Fig. 52 is a graph depicting, in the surface acoustic wave device related to the first embodiment in which LiNbO₃ having the Euler angles (90°, θ, 0°) and a thickness of 0.3λ is stacked on the substrate made of the R-plane sapphire having the Euler angles (0°, 122°23', 0°), the relationship between the Euler angle θ and the acoustic velocity of a surface acoustic wave.
Fig. 53 is a graph depicting, in the surface acoustic wave device related to the first embodiment in which the LiNbO₃ having the Euler angles (90°, θ, 0°) and the thickness of 0.3λ is stacked on the substrate made of the R-plane sapphire having the Euler angles (0°, 122°23', 0°), the relationship between the Euler angle θ and the electromechanical coupling coefficient k².

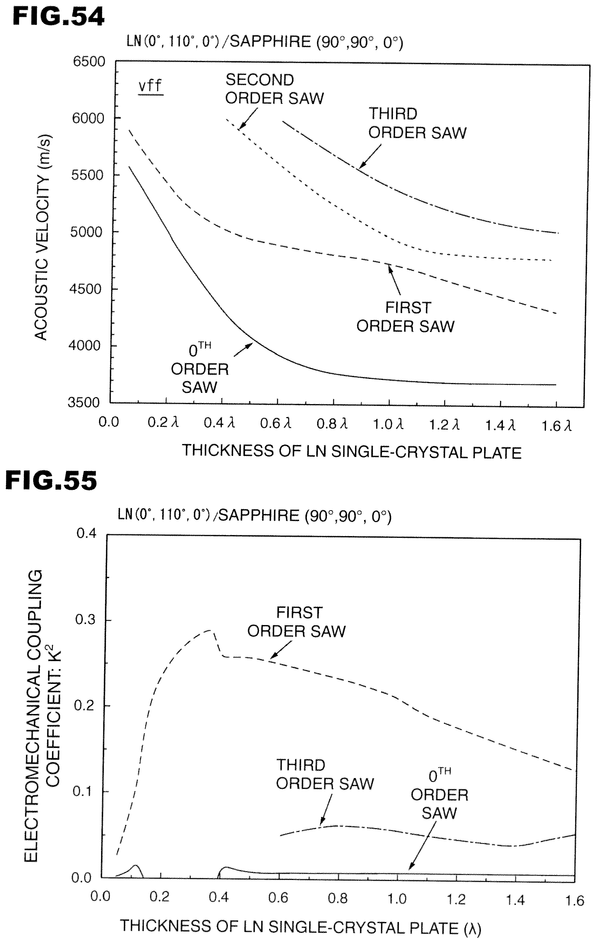

Fig. 54 is a graph depicting, in the surface acoustic wave device according to the first embodiment in which the LiNbO₃ having the Euler angles (0°, 110°, 0°) is stacked on an alumina substrate having the Euler angles (90°, 90°, 0°), the relationship between the thickness of the LiNbO₃ single-crystal plate and the acoustic velocity of a surface acoustic wave.
Fig. 55 is a graph depicting, in the surface acoustic wave device according to the first embodiment in which the LiNbO₃ having the Euler angles (0°, 110°, 0°) is stacked on the alumina substrate having the Euler angles (90°, 90°, 0°), the relationship between the thickness of the LiNbO₃ single-crystal plate and the electromechanical coupling coefficient k².

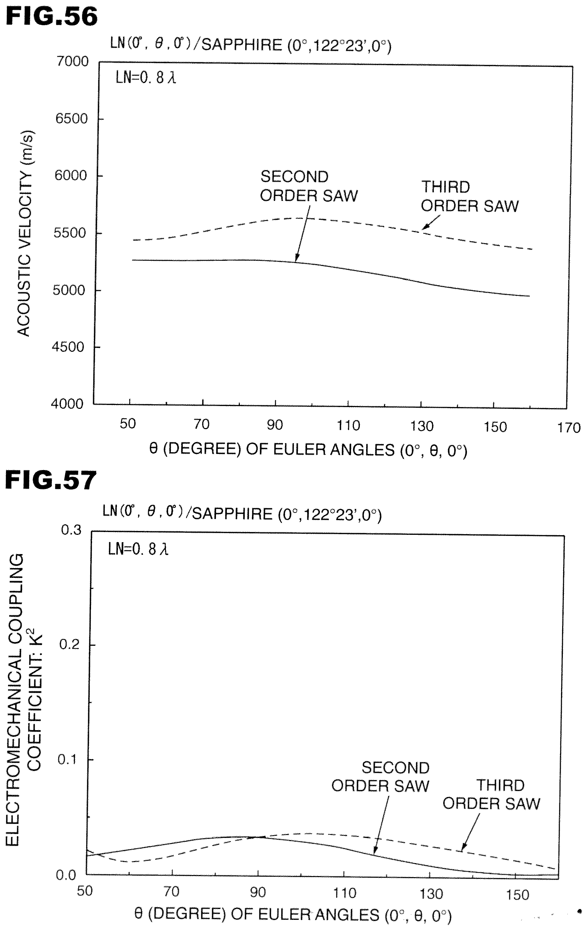

Fig. 56 is a graph depicting, in a structure where a LiNbO₃ single-crystal plate having the Euler angles (0°, θ°, 0°) and a thickness of 0.8λ is stacked on the substrate made of the R-plane sapphire having the Euler angles (0°, 122°23', 0°), the relationship between the Euler angle θ and the acoustic velocity of a surface acoustic wave.
Fig. 57 is a graph depicting, in the structure where the LiNbO₃ single-crystal plate having the Euler angles (0°, θ°, 0°) and the thickness of 0.8λ is stacked on the substrate made of the R-plane sapphire having the Euler angles (0°, 122°23', 0°), the relationship between the Euler angle θ and the electromechanical coupling coefficient k².

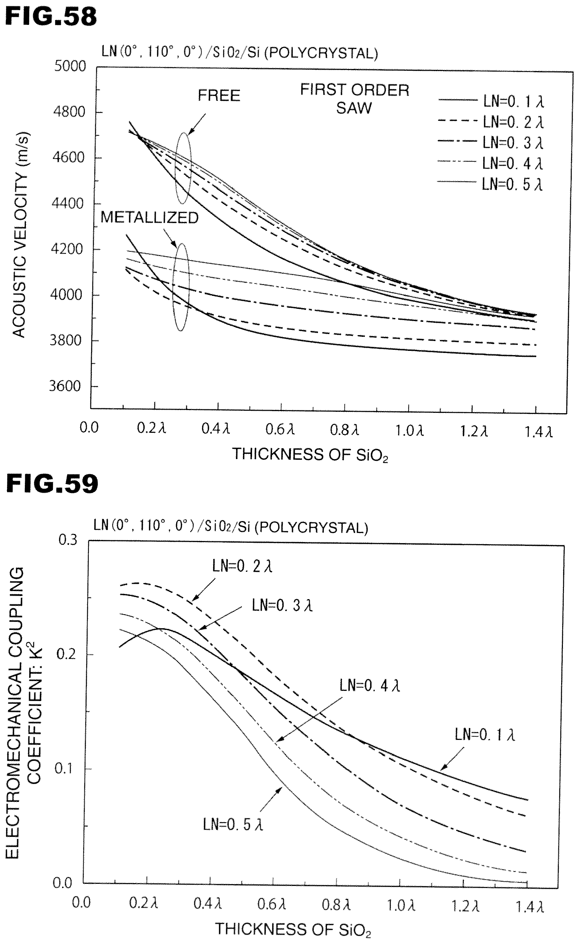

Fig. 58 is a graph depicting, in a structure of the surface acoustic wave device according to the third embodiment, illustrated in Fig. 1(c), where the SiO₂ film and the LiNbO₃ single-crystal plate having the Euler angles (0°, 110°, 0°) are stacked on a polycrystalline Si substrate, the relationship among the thickness of the LiNbO₃ single-crystal plate, the thickness of the SiO₂ film, and the acoustic velocity of a surface acoustic wave in the first order mode.
Fig. 59 is a graph depicting, in the structure of the surface acoustic wave device according to the third embodiment, illustrated in Fig. 1(c), where the SiO₂ film and the LiNbO₃ single-crystal plate having the Euler angles (0°, 110°, 0°) are stacked on the polycrystalline Si substrate, the relationship among the thickness of the LiNbO₃ single-crystal plate, the thickness of the SiO₂ film, and the electromechanical coupling coefficient k² in the first order mode.

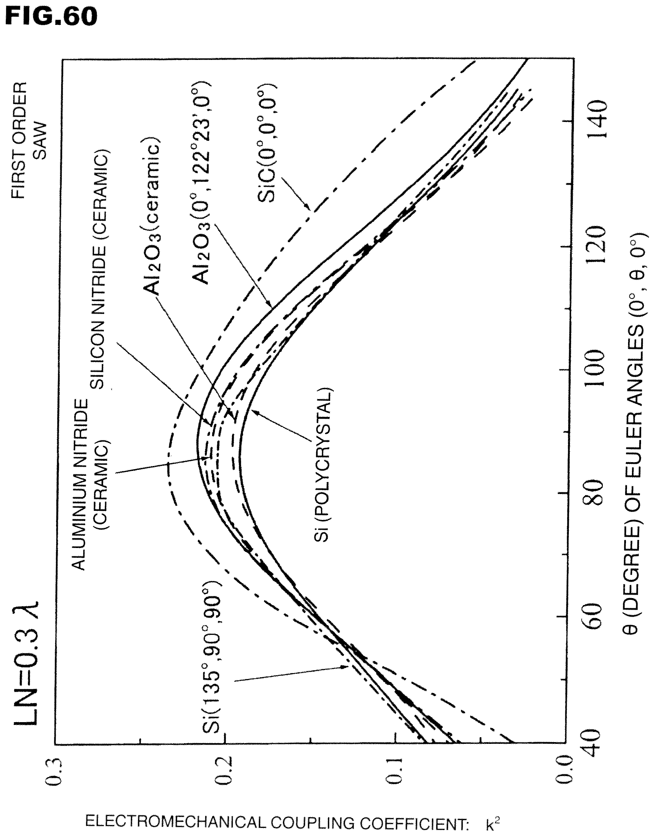

Fig. 60 is a graph depicting, when a substrate made of SiC (0°, 0°, 0°), alumina, aluminum nitride, silicon nitride, Si ((135°, 90°, 90°), or a Si polycrystal is used as a high acoustic-velocity substrate and an LN single-crystal plate having the Euler angles (90°, θ, 0°) and a thickness of 0.3λ is used in the surface acoustic wave device related to the first embodiment, the relationship between the Euler angle θ and the electromechanical coupling coefficient k².

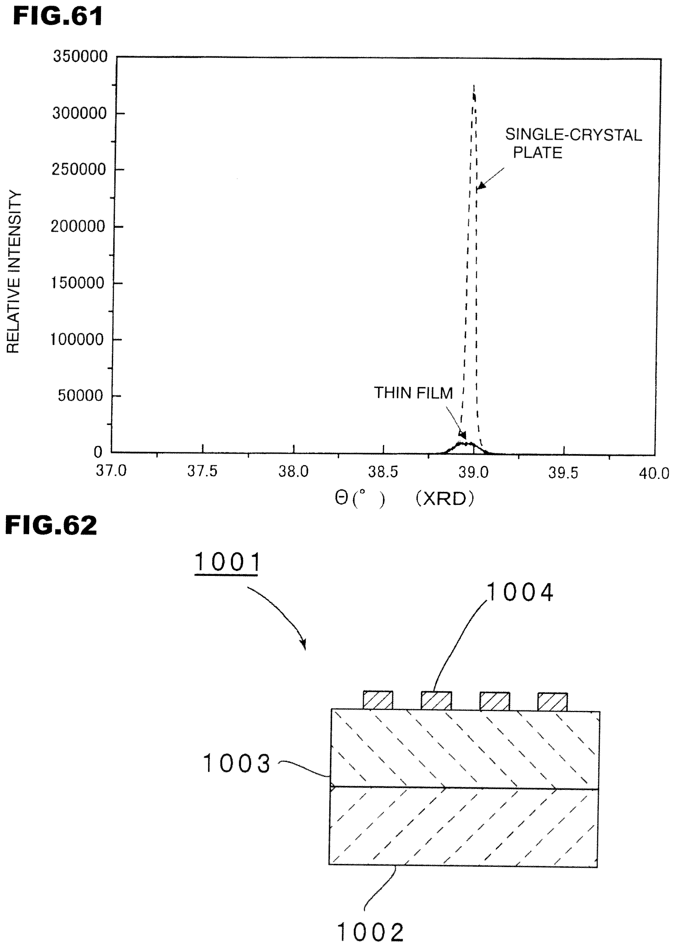

Fig. 61 depicts an X-ray diffraction (XRD) spectrum of a LiNbO₃ single-crystal thin film and the LiNbO₃ single-crystal plate.
Fig. 62 is a sectional view illustrating a surface acoustic wave device of related art.

### Description of Embodiments

The present invention will be clarified from the following description of a practical embodiment of the present invention with reference to the drawings. It is to be noted that, in this Description, the crystal orientation of each of a high acoustic-velocity substrate and a LiNbO₃ single-crystal plate is represented by the Euler angles (φ, θ, ψ). The crystal orientation can also be represented by the Miller indices, for example, instead of the Euler angles. The relationship between the Euler angles and the Miller indices is as follow.

Euler angles (90°, 90°, 0°) = Miller indices (100), and Euler angles (0°, 90°, 0°) = Miller indices (010) or (0-10).

Fig. 1(a) is a front sectional view of a surface acoustic wave device according to a first embodiment of the present invention. A surface acoustic wave device 1 includes a high acoustic-velocity substrate 2. The high acoustic-velocity substrate 2 implies a substrate in which the acoustic velocity of a surface acoustic wave is high. In more detail, the high acoustic-velocity substrate 2 implies a substrate in which the acoustic velocity of a transverse wave is 5400 m/sec or higher and 8660 m/sec or lower. The acoustic velocity of the surface acoustic wave can be increased by using the high acoustic-velocity substrate 2 in which the acoustic velocity of the transverse wave is 5400 m/sec or higher. While the acoustic velocity of the surface acoustic wave can also be increased by using a high acoustic-velocity substrate in which the acoustic velocity of the transverse wave exceeds 8660 m/sec, a substrate material having an acoustic velocity higher than 8660 m/sec is a very expensive material, such as diamond, and the cost of the surface acoustic wave device is quite increased.

Materials of the high acoustic-velocity substrate and the acoustic velocities of the transverse wave, which fall within the above-mentioned range of the acoustic velocity of the transverse wave, are listed in Table 1 below.

**[Table 1]**

| | Acoustic Velocity of Transverse Wave |
|---|---|
| Sapphire | 6070 m/sec |
| Silicon Carbide | 7360 - 8660 m/sec |
| Alumina | 5800 - 6400 m/sec |
| Aluminum Nitride | 5960 - 6560 m/sec |
| Silicon Nitride | 5650 - 6000 m/sec |
| Silicon | 5844 m/sec |
| Magnesium Oxide (MgO) | 6600 m/sec |
| Polycrystalline Silicon | 5400 m/sec |
| Quartz | 4670 m/sec |

In the present invention, the materials of the high acoustic-velocity substrate 2 are not limited to ones listed in Table 1. However, materials being comparatively inexpensive and having a high acoustic velocity, which are selected from a group consisting of sapphire, silicon carbide, alumina, aluminum nitride, silicon, silicon nitride, and MgO listed in Table 1, are preferably used as the materials of the high acoustic-velocity substrate 2.

While R-plane, m-plane, and a-plane sapphire single crystals are used as examples of the sapphire in the present invention, other types of sapphires having azimuth angles, which exhibit the acoustic velocity of 5400 m/sec to 8660 m/sec, may also be used.

A LiNbO₃ single-crystal plate 3 is stacked on the high acoustic-velocity substrate 2. The LiNbO₃ single-crystal plate 3 differs from a LiNbO₃ single-crystal thin film. In more detail, the LiNbO₃ single-crystal plate 3 is obtained, for example, by cutting a bulk LiNbO₃ single crystal. The LiNbO₃ single-crystal plate 3 is obtained in such a way and is bonded to the high acoustic-velocity substrate 2. Thus, the LiNbO₃ single-crystal plate 3 differs from the LiNbO₃ single-crystal thin film that is formed on the high acoustic-velocity substrate by crystal growth. In other words, the LiNbO₃ single-crystal plate 3 obtained from the bulk LiNbO₃ single crystal differs in crystallinity from the LiNbO₃ single-crystal thin film formed by crystal growth.

While the thickness of the LiNbO₃ single-crystal plate 3 is not limited to a particular value, the LiNbO₃ single-crystal plate 3 has a thickness of about 0.05λ or more, and the thickness is usually about 0.15λ to 1.6λ. If the thickness is less than 0.05λ, it would be difficult to form a thin plate. If the thickness is more than 1.6λ, the thickness of the surface acoustic wave device 1 would be increased and it would be difficult to obtain a high acoustic velocity because characteristics come closer to those specific to the LiNbO₃ single crystal alone.

Further, the LiNbO₃ single-crystal thin film has a difficulty in obtaining a good orientation property and hence has a difficulty in obtaining a good piezoelectric characteristic. Fig. 61 depicts the results of measuring a crystallinity characteristic (2θ/ω scan) of the LiNbO₃ single-crystal thin film and the LiNbO₃ single-crystal plate, each having a thickness of 0.5 µm), with an X-ray diffraction (XRD). As seen from Fig. 61, an XRD spectrum of the LiNbO₃ single crystal plate has intensity of 321000 and a half-value width of 0.05°. On the other hand, an XRD spectrum of the LiNbO₃ single-crystal thin film has intensity of 10000, i.e., about 1/30 of 321000, and a half-value width of 0.85°, i.e., about 17 times 0.05°. It is thus understood that the orientation property and the crystallinity of the single-crystal thin film is much poorer than those of the single-crystal plate. This implies that a piezoelectric characteristic (electromechanical coupling coefficient) and the mechanical Q of the single-crystal thin film are much inferior to those of the single-crystal plate. In other words, in the LiNbO₃ single-crystal thin film, a good piezoelectric characteristic is not obtained because of a difficulty in obtaining the orientation property and the crystallinity comparable to those of the single-crystal plate. In contrast, the LiNbO₃ single-crystal plate can easily provide a surface acoustic wave device that is superior in the orientation property, the crystallinity, and the piezoelectric characteristic.

The crystal orientation of the LiNbO₃ single-crystal plate is within the range of the Euler angles (0°, 67° to 160°, -5° to +5°) according to the embodiment or (90°, 51° to 133°, -5° to +5°) in a related device. With the crystal orientation held within that range, the electromechanical coupling coefficient k² can be increased as described later.

A method of stacking and joining the LiNbO₃ single-crystal plate 3 to the high acoustic-velocity substrate 2 is not limited to a particular one. For example, a method of affixing the LiNbO₃ single-crystal plate 3 onto the high acoustic-velocity substrate 2 and diffusion-bonding the former to the latter under heating, or a method of utilizing eutectic bonding with gold, for example, can be used as required.

An electrode 4 is formed on the LiNbO₃ single-crystal plate 3. The electrode 4 can be formed by using a suitable metal, such as Al, Pt, Cu, Au or Ni, or a suitable alloy.

The surface acoustic wave device 1 of this embodiment is characterized in that the acoustic velocity of the surface acoustic wave can be increased by using the high acoustic-velocity substrate 2, and that a higher acoustic velocity and a larger electromechanical coupling coefficient k² can be realized by using the LiNbO₃ single-crystal plate 3 having the above-mentioned specific Euler angles.

As described above, the related-art surface acoustic wave device using the LiNbO₃ thin film has the problem that the range of the Euler angles within which the electromechanical coupling coefficient k² can be increased is very narrow. In a structure where an epitaxial LiNbO₃ thin film is stacked on (012) sapphire, for example, a LiNbO₃ film of (100), i.e., having the Euler angles (90°, 90°, 0°), has to be used.

In contrast, according to the present invention, the LiNbO₃ single-crystal plate having the above-mentioned wide range of the Euler angles can be used, and hence an increase in both the acoustic velocity of the surface acoustic wave and the electromechanical coupling coefficient k² can be easily realized.

The present invention is not limited to the first embodiment described above, and the present invention may also be practiced as surface acoustic wave devices 11 and 21 according to second and third embodiments illustrated in Figs. 1(b) and 1(c), respectively. In the surface acoustic wave device 11 illustrated in Fig. 1(b), a SiO₂ film 5 is formed on the LiNbO₃ single-crystal plate 3 so as to cover the electrode 4. Further, in the surface acoustic wave device 21 illustrated in Fig. 1(c), a SiO₂ film 5A is formed between the high acoustic-velocity substrate 2 and the LiNbO₃ single-crystal plate 3. By using the SiO₂ film 5 or 5A as in the surface acoustic wave device 11 or 21, it is possible to reduce an absolute value of the temperature coefficient of resonance frequency TCF, and to increase stability in characteristics with respect to temperature change.

A point of increasing the acoustic velocity of the surface acoustic wave and the electromechanical coupling coefficient k² in the structure where the LiNbO₃ single-crystal plate 3 having the Euler angles in the above-mentioned specific range is stacked on the high acoustic-velocity substrate will be described below in connection with concrete experimental examples.

The surface acoustic wave employed in the present invention is a leaky surface acoustic wave rather than a 0-th order wave, i.e., a Rayleigh wave. The leaky surface acoustic wave is not limited to a surface acoustic wave in the first order mode, and it may be a surface acoustic wave in the second order or third order mode. The acoustic velocity can be further increased by using a surface acoustic wave in the higher mode.

It is to be noted that, in the following description, LiNbO₃ is abbreviated to LN in some cases.

### [Examples of Structure Using High Acoustic-Velocity Substrate Made of Silicon Carbide SiC]

Fig. 2 is a graph depicting, in a structure where an LN single-crystal plate having the Euler angles (0°, 0°, 0°) is stacked on a SiC substrate having the Euler angles (0°, 0°, 0°), the relationship between the thickness of the LN single-crystal plate and the acoustic velocity of a surface acoustic wave, and Fig. 3 depicts the relationship between the thickness of the LN single-crystal plate and the electromechanical coupling coefficient k².

In an ordinary surface acoustic wave device, the acoustic velocity of a surface acoustic wave is about 4000 m/sec. As seen from Fig. 2, in any of the surface acoustic wave in the 0-th order, the surface acoustic wave in the first order mode, the surface acoustic wave in the second order mode, and the surface acoustic wave in the third order mode, the acoustic velocity decreases as the thickness of the LiNbO₃ single-crystal plate 3 increases in the range of 0 to 1.0λ.

It is, however, understood that, when the surface acoustic waves in the first order mode, in the second order mode and in the third order mode are used, the acoustic velocity is as high as, or higher than, 4500 m/sec over the entire range of 0 to 1.0λ for the thickness of the LN single-crystal plate 3. For example, the acoustic velocity of the surface acoustic wave in the first order mode is in the range of 4500 m/sec to 4750 m/sec when the thickness of the LN single-crystal plate 3 is in the range of 0 to 1.0λ. Thus, the acoustic velocity of the surface acoustic wave can be sufficiently increased.

Also, it is understood that, when the surface acoustic wave in the second order mode or the surface acoustic wave in the third order mode is used, the acoustic velocity of the surface acoustic wave can be further increased in comparison with the case using the surface acoustic wave in the first order mode.

On the other hand, as seen from Fig. 3, when the surface acoustic wave in the first order mode is used, the electromechanical coupling coefficient k² is relatively high, i.e., 0.04 or more, at the thickness of the LN single-crystal plate in the range of 0.15 to 1.0λ, but it is smaller than those of LN single-crystal plates (described later) having other Euler angles, according to this application, in the case of the first order mode.

Similarly, when the second order mode or the third order mode is used, the electromechanical coupling coefficient is relatively small, i.e., 0.02 or less.

Thus, it is understood from the results of Figs. 2 and 3 that, when the thickness of the LN single-crystal plate having the Euler angles (0°, 0°, 0°) is set to the range of 0.15λ to 1.0λ, the acoustic velocity of the surface acoustic wave in the first order mode can be increased, but the electromechanical coupling coefficient k² cannot be so increased.

Figs. 4 and 5 are graphs depicting, when a structure of LN (90°, 87°, 0°) / SiC (0°, 0°, 0°) is used, the relationship between the thickness of the LN single-crystal plate and the acoustic velocity of a surface acoustic wave and the electromechanical coupling coefficient, respectively.

As seen from Fig. 4, when the crystal orientation of LN is (90°, 87°, 0°), the acoustic velocity of the surface acoustic wave in the first order mode is as high as, or higher than, 4400 m/sec for thickness of the LN single-crystal plate in the range of 0.05λ to 1.6λ. The acoustic velocity of the surface acoustic wave can be further increased by using the second order mode or the third order mode.

On the other hand, as seen from Fig. 5, in the case using the surface acoustic wave in the first order mode, the electromechanical coupling coefficient k² can be effectively increased to 0.115 or more when the thickness of the LN single-crystal plate is preferably set to the range of 0.15λ to 1.6λ. Moreover, by setting the LN thickness to the range of 0.07λ to 0.12λ, the electromechanical coupling coefficient k² can be increased to 0.05 or more and a high acoustic velocity of 6500 m/sec or higher can be obtained. When the surface acoustic wave in the second order mode is used, the electromechanical coupling coefficient k² can be increased to 0.04 or more by setting the thickness to the range of 0.27λ to 1.6λ.

Accordingly, when the LN single-crystal plate 3 having the Euler angles (90°, 87°, 0°) is used, the thickness of the LN single-crystal plate 3 is preferably set to the range of 0.15λ to 1.6λ in the case using the first order mode. On those conditions, it is possible to not only increase the acoustic velocity of the surface acoustic wave, but also to effectively increase the electromechanical coupling coefficient k². In order to increase the acoustic velocity to 4560 m/sec or higher and the electromechanical coupling coefficient k² to 0.15 or more, the thickness of the LN single-crystal plate is more preferably set to the range of 0.18λ to 0.9λ.

Further, when the surface acoustic wave in the second order mode is used, as described above, the thickness of the LN single-crystal plate is preferably set to the range of 0.27λ to 1.6λ. On that condition, the acoustic velocity of the surface acoustic wave can be raised to 5050 m/sec or higher, and the electromechanical coupling coefficient k² can be increased to 0.04 or more. By setting the thickness to the range of 0.38λ to 1.23λ, more preferably, a high acoustic velocity of 5250 m/sec or higher and a large electromechanical coupling coefficient k² of 0.07 or more can be obtained.

When the surface acoustic wave in the third order mode is used, the acoustic velocity of 5100 m/sec or higher and the electromechanical coupling coefficient k² of 0.025 or more can be obtained at the thickness of the LN single-crystal plate between 0.4λ and 1.6λ. Further, the electromechanical coupling coefficient k² of 0.04 or more can be obtained at the thickness of the LN single-crystal plate between 0.4λ and 0.53λ and between 1.18λ and 1.6λ.

Figs. 6 and 7 are graphs depicting, when structures of LN (90°, 87°, 0°) / R-plane sapphire (0°, 122°23', 0°), sapphire (0°, 90°, 0°), and sapphire (90°, 90°, 0°) are used, the relationship between the thickness of the LN single-crystal plate and the acoustic velocity of a surface acoustic wave and the electromechanical coupling coefficient k², respectively.

As seen from Fig. 6, when the crystal orientation of LN is (90°, 87°, 0°), the acoustic velocity of the surface acoustic wave in the first order mode is as high as, or higher than, 4450 m/sec when the thickness of the LN single-crystal plate is in the range of 0 to 1.6λ, and hence the acoustic velocity of the surface acoustic wave can be increased in that range.

On the other hand, as seen from Fig. 7, when the surface acoustic wave in the first order mode is used, the electromechanical coupling coefficient k² can be increased to 0.1 or more by setting the thickness of the LN single-crystal plate to the range of 0.15λ to 1.6λ.

Accordingly, when the LN single-crystal plate 3 having the Euler angles (90°, 87°, 0°) is used, the thickness of the LN single-crystal plate 3 is preferably set to the range of 0.15λ to 1.6λ in the case using the first order mode. In those conditions, it is possible to not only increase the acoustic velocity of the surface acoustic wave, but also to effectively increase the electromechanical coupling coefficient k². In order to increase the acoustic velocity to 4560 m/sec or higher and the electromechanical coupling coefficient k² to 0.15 or more, the thickness of the LN single-crystal plate is more preferably set to the range of 0.2λ to 0.8λ.

Figs. 8 and 9 are graphs depicting, when a structure of LN (0°, 90°, 0°) / SiC (0°, 0°, 0°) is used, the relationship between the thickness of the LN single-crystal plate and the acoustic velocity of a surface acoustic wave and the electromechanical coupling coefficient, respectively.

As seen from Fig. 8, when the crystal orientation of LN is (0°, 90°, 0°), the acoustic velocity of the surface acoustic wave in the first order mode is as high as, or higher than, 4350 m/sec when the thickness of the LN single-crystal plate is in the range of 0 to 1.4λ. The acoustic velocity of the surface acoustic wave can be further increased by using the second order mode or the third order mode.

On the other hand, as seen from Fig. 9, when the surface acoustic wave in the first order mode is used, the electromechanical coupling coefficient k² can be increased to 0.15 or more by setting the thickness of the LN single-crystal plate to the range of 0.15λ to 1.4λ. Moreover, when the surface acoustic wave in the second order mode is used, the electromechanical coupling coefficient k² can be increased to 0.02 or more by setting the thickness to the range of 0.3λ to 1.6λ.

Accordingly, when the LN single-crystal plate 3 having the Euler angles (0°, 90°, 0°) is used, the thickness of the LN single-crystal plate 3 is preferably set to the range of 0.15λ to 1.6λ in the case using the first order mode. On those conditions, it is possible to not only increase the acoustic velocity of the surface acoustic wave, but also to effectively increase the electromechanical coupling coefficient k². When a larger electromechanical coupling coefficient k² is demanded, the electromechanical coupling coefficient k² of 0.2 or more can be obtained by more preferably setting the thickness of the LN single-crystal plate to the range of 0.2λ to 1.0λ.

Further, when the surface acoustic wave in the second order mode is used, as described above, the acoustic velocity of the surface acoustic wave and the electromechanical coupling coefficient k² can be both increased by setting the thickness of the LN single-crystal plate to the range of 0.2λ to 1.6λ. Moreover, the electromechanical coupling coefficient k² of 0.025 or more can be obtained by setting the thickness of the LN single-crystal plate to the range of 0.37λ to 0.43λ or 0.93λ to 1.6λ.

In the case using the third order mode, the acoustic velocity of 5100 m/sec or higher and the electromechanical coupling coefficient k² of 0.025 or more can be obtained by setting the thickness of the LN single-crystal plate to the range of 0.4λ to 1.6λ. Further, the acoustic velocity of 5400 m/sec or higher and the electromechanical coupling coefficient k² of 0.05 or more can be obtained by setting the thickness of the LN single-crystal is to the range of 0.4λ to 1.15λ.

Figs. 10 and 11 are graphs depicting, when a structure of LN (0°, 110°, 0°) / SiC (0°, 0°, 0°) is used, the relationship between the thickness of the LN single-crystal plate and the acoustic velocity of a surface acoustic wave and the electromechanical coupling coefficient, respectively.

As seen from Fig. 10, when the crystal orientation of LN is (0°, 110°, 0°), the acoustic velocity of the surface acoustic wave in the first order mode is as high as equal to or higher than 4750 m/sec at the thickness of the LN single-crystal plate in the range of 0 to 1.6λ. The acoustic velocity of the surface acoustic wave can be further increased by using the second order mode or the third order mode.

On the other hand, as seen from Fig. 11, when the surface acoustic wave in the first order mode is used, the electromechanical coupling coefficient k² can be increased to 0.15 or more by setting the thickness of the LN single-crystal plate to the range of 0.14λ to 1.6λ. When the surface acoustic wave in the second order mode is used, the electromechanical coupling coefficient k² can be increased to 0.02 or more by setting the thickness to the range of 0.2λ to 0.62λ or 0.97λ to 1.6λ. Moreover, the electromechanical coupling coefficient k² of 0.025 or more can be obtained by setting the thickness of the LN single-crystal plate to the range of 0.2λ to 0.55λ or 1.05λ to 1.6λ.

Accordingly, when the LN single-crystal plate 3 having the Euler angles (0°, 110°, 0°) is used, the thickness of the LN single-crystal plate 3 is preferably set to the range of 0.14λ to 1.6λ in the case employing the first order mode. In those conditions, it is possible to not only increase the acoustic velocity of the surface acoustic wave, but also to effectively increase the electromechanical coupling coefficient k². When a larger electromechanical coupling coefficient k² is demanded, the electromechanical coupling coefficient of 0.2 or more can be obtained by more preferably setting the thickness of the LN single-crystal plate to the range of 0.18λ to 1.17λ.

Further, when the surface acoustic wave in the second order mode is used, as described above, the acoustic velocity of the surface acoustic wave and the electromechanical coupling coefficient k² can be both increased by setting the thickness of the LN single-crystal plate to the range of 0.2λ to 0.62λ or 0.97λ to 1.6λ.

When the surface acoustic wave in the third order mode is used, the acoustic velocity of 5300 m/sec or higher and the electromechanical coupling coefficient k² of 0.03 or more can be obtained by setting the thickness of the LN single-crystal plate to the range of 0.35λ to 1.6λ. Further, the electromechanical coupling coefficient k² of 0.05 or more can be obtained by setting the thickness of the LN single-crystal plate to the range of 0.42λ to 1.42λ.

### [LN Single-Crystal Plate / R-Plane Sapphire (0°, 122°23', 0°)]

Figs. 12 and 13 are graphs depicting, when a structure of LN (0°, 110°, 0°) / R-plane sapphire (0°, 122°23', 0°) is used, the relationship between the thickness of the LN single-crystal plate and the acoustic velocity of a surface acoustic wave and the electromechanical coupling coefficient, respectively.

As seen from Fig. 12, when the crystal orientation of LN is (0°, 110°, 0°), the acoustic velocity of the surface acoustic wave in the first order mode is as high as, or higher than, 4400 m/sec when the thickness of the LN single-crystal plate is in the range of 0.05λ to 1.0λ. The acoustic velocity of the surface acoustic wave can be further increased by using the second order mode or the third order mode.

On the other hand, as seen from Fig. 13, when the surface acoustic wave in the first order mode is used, the electromechanical coupling coefficient k² can be increased to 0.125 or more by setting the thickness of the LN single-crystal plate to the range of 0.11λ to 1.6λ. When the surface acoustic wave in the second order mode is used, the electromechanical coupling coefficient k² can be increased to 0.025 or more by setting the thickness to the range of 0.12λ to 1.6λ.

Accordingly, when the LN single-crystal plate 3 having the Euler angles (0°, 110°, 0°) is used, the thickness of the LN single-crystal plate 3 is preferably set to the range of 0.11λ to 1.6λ in the case employing the first order mode. In those conditions, it is possible to not only increase the acoustic velocity of the surface acoustic wave, but also to effectively increase the electromechanical coupling coefficient k². In order to increase the electromechanical coupling coefficient k² to 0.2 or more, the thickness of the LN single-crystal plate is more preferably set to the range of 0.17λ to 1.02λ.

Further, when the surface acoustic wave in the second order mode is used, as described above, the acoustic velocity of the surface acoustic wave and the electromechanical coupling coefficient k² can be both increased by setting the thickness of the LN single-crystal plate to the range of 0.2λ to 1.6λ. Moreover, the electromechanical coupling coefficient k² of 0.03 or more can be obtained by setting the thickness of the LN single-crystal plate to the range of 0.2λ to 0.42λ or 0.95λ to 1.6λ.

When the surface acoustic wave in the third order mode is used, the acoustic velocity of 5100 m/sec or higher and the electromechanical coupling coefficient k² of 0.025 or more can be obtained by setting the thickness of the LN single-crystal plate to the range of 0.4λ to 1.6λ. Further, the electromechanical coupling coefficient k² of 0.03 or more can be obtained by setting the thickness of the LN single-crystal plate to the range of 0.6λ to 1.55λ.

In any of the cases of Figs. 5, 7, 9, 11 and 13, the electromechanical coupling coefficient k² can be increased to 0.02 or more by setting the thickness of the LiNbO₃ single-crystal plate 3 to the range of 0.14λ to 1.6λ. In Figs. 5, 7, 9, 11 and 13, particularly, the electromechanical coupling coefficient k² in the first order mode can be further increased to 0.115 or more.

### [LN (0°, 110°, 0°) / Sapphire (0°, 90°, 0°)]

Fig. 50 is a graph depicting, in a structure of the surface acoustic wave device according to the first embodiment, illustrated in Fig. 1(a), where the high acoustic-velocity substrate 2 is made of sapphire having the Euler angles (0°, 90°, 0°) and the LN single-crystal plate 3 has the Euler angles (0°, 110°, 0°), the relationship between the acoustic velocity of a surface acoustic wave in each of the 0-th order mode, the first order mode, the second order mode and the third order mode and the thickness of the LN single-crystal plate. Fig. 51 depicts the relationship between the thickness of the LN single-crystal plate and the electromechanical coupling coefficient k².

As seen from Fig. 50, the acoustic velocity of the surface acoustic wave in the first order mode is as high as, or higher than, 4400 m/sec over the entire range of 1.6λ or less for the thickness of the LN single-crystal plate. By using the surface acoustic wave in the second order mode or the third order mode, the acoustic velocity of the surface acoustic wave can be further increased when the thickness of the LN plate is the range of 0.4λ to 1.6λ or 0.5λ to 1.6λ, respectively.

As seen from Fig. 51, when the surface acoustic wave in the first order mode is used, the thickness of the LN single-crystal plate is preferably in the range of 0.27λ to 0.6λ. In that case, the electromechanical coupling coefficient k² can be increased to 0.25 or more.

Further, when the surface acoustic wave in the second order mode is used, the electromechanical coupling coefficient k² can be increased to 0.02 or more by setting the thickness of the LN single-crystal plate to the range of 0.4λ to 1.6λ. When the surface acoustic wave in the third order mode is used, the electromechanical coupling coefficient k² can be increased to 0.02 or more by setting the thickness of the LN single-crystal plate to the range of 0.6λ to 1.6λ.

### [LN (0°, 110°, 0°) / Sapphire (90°, 90°, 0°)]

Fig. 54 is a graph depicting, in a structure of the surface acoustic wave device according to the first embodiment, illustrated in Fig. 1(a), where the high acoustic-velocity substrate 2 is made of sapphire having the Euler angles (90°, 90°, 0°) and the LN single-crystal plate 3 has the Euler angles (0°, 110°, 0°), the relationship between the thickness of the LN single-crystal plate and the acoustic velocity of a surface acoustic wave in each of the 0-th order mode, the first order mode, the second order mode and the third order mode. Fig. 55 depicts the relationship between the thickness of the LN single-crystal plate 3 and the electromechanical coupling coefficient k².

As seen from Fig. 54, when the surface acoustic wave in the first order mode is used in the relevant structure, the acoustic velocity is as high as, or higher than, 4350 m/sec over the entire range of 1.6λ or less for the thickness of the LN single-crystal plate. When the surface acoustic wave in the second order mode or the surface acoustic wave in the third order mode is used, the acoustic velocity of the surface acoustic wave can be further increased respectively to 5000 m/sec or higher or 5250 m/sec or higher over the entire range of 0.4λ to 1.6λ or 0.6λ to 1.6λ for the thickness of the LN single-crystal plate.

On the other hand, as seen from Fig. 55, when the surface acoustic wave in the first order mode is used, the electromechanical coupling coefficient k² is in the range of 0.05 to 0.1 when the thickness of the LN single-crystal plate is in the range of 0.05λ to 0.1λ, while the acoustic velocity is beneficially as high as 5700 m/sec. Further, the electromechanical coupling coefficient k² is as high as, or larger than, 0.1 when the thickness of the LN single-crystal plate is in the range of 0.1λ to 1.6λ. When the surface acoustic wave in the second order mode is used, the electromechanical coupling coefficient k² is 0.015 or more at the thickness of the LN single-crystal plate in the range of 0.4λ to 1.6λ. When the surface acoustic wave in the third order mode is used, the electromechanical coupling coefficient k² can be increased to 0.05 or more at the thickness of the LN single-crystal plate in the range of 0.6λ to 1.6λ.

Figs. 14 and 15 are graphs depicting, when a structure of LN (0°, 110°, 0°) / Si (135°, 90°, 90°) is used, the relationship between the thickness of the LN single-crystal plate and the acoustic velocity of a surface acoustic wave and the electromechanical coupling coefficient, respectively. For comparison, Figs. 14 and 15 further depict the results obtained by using quartz instead of Si (135°, 90°, 90°).

As seen from Fig. 15, when the crystal orientation of LN is (0°, 110°, 0°), the acoustic velocity of the surface acoustic wave in the first order mode is as high as, or higher than, 4500 m/sec at the thickness of the LN single-crystal plate in the range of 0.05λ to 1.0λ. Thus, the acoustic velocity of the surface acoustic wave can be increased in that range.

On the other hand, as seen from Fig. 14, when the surface acoustic wave in the first order mode is used, the electromechanical coupling coefficient k² can be increased to 0.14 or more by setting the thickness of the LN single-crystal plate to the range of 0.08λ to 1.0λ in the structure where the LN single-crystal plate is disposed on Si (135°, 90°, 90°).

### [Dependency on Euler Angle θ]

Figs. 16 and 17 are graphs depicting, in a structure of LN (0°, θ, 0°) / SiC (0°, 0°, 0°), the relationship between θ of the Euler angles (0°, θ, 0°) and the acoustic velocity of a surface acoustic wave and the electromechanical coupling coefficient k², respectively. It is to be noted that, in Figs. 16 and 17, the thickness of the LN single-crystal plate 3 is set to 0.3λ. Also, in Figs. 18 to 27 described later, the thickness of the LN single-crystal plate is set to 0.3λ.

As seen from Fig. 16, the acoustic velocity of the surface acoustic wave in the first order mode is as high as equal to or higher than 5100 m/sec at the Euler angle θ of the LN single-crystal plate 3 in the range of 70° to 160°.

On the other hand, as seen from Fig. 17, the electromechanical coupling coefficient k² for the surface acoustic wave in the first order mode is as large as, or larger than, 0.18 when the Euler angle θ of the LN single-crystal plate 3 is in the range of 70° to 160°. More preferably, the electromechanical coupling coefficient k² is increased to 0.225 or more in the range of 80° to 135°. Even more preferably, the electromechanical coupling coefficient k² is increased to 0.27 or more in the range of 92° to 115°.

Further, when the surface acoustic wave in the second order mode is used, the electromechanical coupling coefficient k² can be increased to 0.025 or more at the Euler angle θ in the range of 94° to 170°.

Figs. 18 and 19 are graphs depicting, in a structure of LN (0°, θ, 0°) / R-plane sapphire (0°, 122°23', 0°), the relationship between θ of the Euler angles (0°, θ, 0°) and the acoustic velocity of a surface acoustic wave and the electromechanical coupling coefficient k², respectively.

As seen from Fig. 18, the acoustic velocity of the surface acoustic wave in the first order mode is as high as, or higher than, 5050 m/sec when the Euler angle θ of the LN single-crystal plate 3 is in the range of 70° to 160°.

On the other hand, as seen from Fig. 19, the Euler angle θ of the LN single-crystal plate 3 is preferably in the range of 67° to 147°. On that condition, the electromechanical coupling coefficient k² for the surface acoustic wave in the first order mode is as large as, or larger than, 0.15. More preferably, the electromechanical coupling coefficient k² is increased to 0.2 or more at θ in the range of 80° to 133°. Even more preferably, the electromechanical coupling coefficient k² of 0.24 or more can be obtained in the range of 93° to 122°.

Figs. 20 and 21 are graphs depicting, in a structure of LN (0°, θ, 0°) / alumina Al₂O₃, the relationship between θ of the Euler angles (0°, θ, 0°) and the acoustic velocity of a surface acoustic wave and the electromechanical coupling coefficient k², respectively.

As seen from Fig. 20, the acoustic velocity of the surface acoustic wave in the first order mode is as high as, or higher than, 4900 m/sec when the Euler angle θ of the LN single-crystal plate 3 is in the range of 70° to 160°.

On the other hand, as seen from Fig. 21, the Euler angle θ of the LN single-crystal plate 3 is preferably in the range of 70° to 160°. On that condition, the electromechanical coupling coefficient k² for the surface acoustic wave in the first order mode is as large as, or larger than, 0.11. More preferably, the electromechanical coupling coefficient k² is increased to 0.18 or more at θ in the range of 80° to 138°. Even more preferably, the electromechanical coupling coefficient k² of 0.2 or more can be obtained at θ in the range of 92° to 132°.

Figs. 22 and 23 are graphs depicting, in a structure of LN (0°, θ, 0°) / aluminum nitride, the relationship between θ of the Euler angles (0°, θ, 0°) and the acoustic velocity of a surface acoustic wave and the electromechanical coupling coefficient k², respectively.

As seen from Fig. 22, the acoustic velocity of the surface acoustic wave in the first order mode is satisfactorily as high as, or higher than, 4800 m/sec when the Euler angle θ of the LN single-crystal plate 3 is in the range of 70° to 160°.

On the other hand, as seen from Fig. 23, the Euler angle θ of the LN single-crystal plate 3 is preferably in the range of 70° to 150°. On that condition, the electromechanical coupling coefficient k² for the surface acoustic wave in the first order mode is as large as, or larger than, 0.13. More preferably, the electromechanical coupling coefficient k² of 0.175 or more is obtained in the range of 80° to 140°. Even more preferably, the electromechanical coupling coefficient k² of 0.22 or more can be obtained in the range of 93° to 130°.

Figs. 24 and 25 are graphs depicting, in a structure of LN (0°, θ, 0°) / silicon nitride, the relationship between θ of the Euler angles (0°, θ, 0°) and the acoustic velocity of a surface acoustic wave and the electromechanical coupling coefficient k², respectively.

As seen from Fig. 24, the acoustic velocity of the surface acoustic wave in the first order mode is as high as, or higher than, 4700 m/sec when the Euler angle θ of the LN single-crystal plate 3 is in the range of 70° to 160°.

On the other hand, as seen from Fig. 25, when the surface acoustic wave in the first order mode is used, the Euler angle θ of the LN single-crystal plate 3 is preferably in the range of 70° to 153°. On that condition, the electromechanical coupling coefficient k² is 0.12 or more. More preferably, the electromechanical coupling coefficient k² is increased to 0.17 or more at θ in the range of 80° to 140°. Even more preferably, the electromechanical coupling coefficient k² of 0.22 or more can be obtained in the range of 93° to 126°.

Figs. 26 and 27 are graphs depicting, in structures of LN (0°, θ, 0°) / Si (135°, 90°, 90°) and LN (0°, θ, 0°) / Si (polycrystal), the relationship between θ of the Euler angles (0°, θ, 0°) and the acoustic velocity of a surface acoustic wave and the electromechanical coupling coefficient k², respectively.

In the structure of LN (0°, θ, 0°) / Si (135°, 90°, 90°), as seen from Fig. 26, the acoustic velocity of the surface acoustic wave in the first order mode is as high as, or higher than, 4650 m/sec when the Euler angle θ of the LN single-crystal plate 3 is in the range of 70° to 160°.

Also, in the structure of LN (0°, θ, 0°) / Si (135°, 90°, 90°), as seen from Fig. 27, the Euler angle θ of the LN single-crystal plate 3 is preferably in the range of 75° to 152° when the surface acoustic wave in the first order mode is used. On those conditions, the electromechanical coupling coefficient k² is as large as equal to or larger than 0.15. More preferably, the electromechanical coupling coefficient k² of 0.22 or more can be obtained in the range of 92° to 127°.

In the structure of LN (0°, θ, 0°) / Si (polycrystal), as seen from Fig. 26, the acoustic velocity of the surface acoustic wave in the first order mode is as high as, or higher than, 4800 m/sec when the Euler angle θ of the LN single-crystal plate 3 is in the range of 70° to 160°.

Also, in the structure of LN (0°, θ, 0°) / Si (polycrystal), as seen from Fig. 27, the Euler angle θ of the LN single-crystal plate 3 is preferably in the range of 75° to 148° when the surface acoustic wave in the first order mode is used. In those conditions, the electromechanical coupling coefficient k² is as large as, or larger than, 0.15. More preferably, the electromechanical coupling coefficient k² of 0.22 or more is obtained in the range of 95° to 122°.

As understood from Figs. 16 to 27, the optimum Euler angle of the LN single-crystal plate is substantially the same regardless of the type of the high acoustic-velocity substrate. For the second and third order modes, Figs. 56 and 57 depict dependency of the acoustic velocity and the electromechanical coupling coefficient k² on the Euler angle in connection with the case using an R-plane sapphire substrate as a representative example when the LN thickness is 0.8λ. As seen from Fig. 56, in both the second and third order modes, the acoustic velocity of 4950 m/sec or higher is obtained at the Euler angle θ in the range of 70° to 160°. As seen from Fig. 57, in the second order mode, the electromechanical coupling coefficient k² of 0.02 or more is obtained at θ in the range of 50° to 120°, the electromechanical coupling coefficient k² of 0.025 or more is obtained in the range of 65° to 113°, and the electromechanical coupling coefficient k² of 0.03 or more is obtained in the range of 82° to 88°. On the other hand, for the surface acoustic wave in the third order mode, the electromechanical coupling coefficient k² of 0.02 or more is obtained at θ in the range of 50° to 53° and of 83° to 140°, the electromechanical coupling coefficient k² of 0.025 or more is obtained in the range of 87° to 123°, and the electromechanical coupling coefficient k² of 0.03 or more is obtained in the range of 93° to 113°.

### [Structure of SiO₂ / LN (0°, 110°, 0°) / R-Plane Sapphire (0°, 122°23', 0°)]

Figs. 28 and 29 are graphs depicting, when the high acoustic-velocity substrate 2 is made of the R-plane sapphire (0°, 122°23', 0°) and the Euler angles of the LN single-crystal plate 3 are (0°, 110°, 0°) in the surface acoustic wave device 11 according to the second embodiment, which includes the SiO₂ film 5 as illustrated in Fig. 1(b), the relationship between the thickness of the SiO₂ film and the acoustic velocity of a surface acoustic wave and the electromechanical coupling coefficient k², respectively. The thickness of the LN single-crystal plate 3 is 0.3λ.

In the structure including the stacked SiO₂ film, as seen from Figs. 28 and 29, the acoustic velocity of the surface acoustic wave in any of the first order mode, the second order mode and the third order mode is as high as, or higher than, 4250 m/sec when the thickness of the SiO₂ film is in the range of 0.03λ to 0.4λ. Additionally, as is apparent from Fig. 28, the acoustic velocity of the surface acoustic wave increases as the thickness of the SiO₂ film reduces. Thus, the acoustic velocity of the surface acoustic wave can be increased over the entire range of 0.4λ or less for the thickness of the SiO₂ film.

As seen from Fig. 29, the electromechanical coupling coefficient k² for the surface acoustic wave in the first order mode is as large as, or larger than, 0.1 when the thickness of the SiO₂ film is in the range of 0.03λ to 0.3λ.

On the other hand, when the surface acoustic wave in the second order mode is used, it is seen that because the thickness 0.3λ of the LN single-crystal plate implies a film thickness at which excitation of the second order mode is started, the excitation occurs at the thickness of the SiO₂ film only in the range of 0.25λ to 0.4λ and the electromechanical coupling coefficient k² is 0.05 or more.

Further, when the surface acoustic wave in the third order mode is used, the third order mode is excited at the thickness of the SiO₂ film only in the range of 0.3λ to 0.4λ and the electromechanical coupling coefficient k² can be obtained as a larger value, i.e., 0.075 or more, than when the surface acoustic wave in the second order mode is used.

### [Temperature Coefficient of Resonance Frequency TCF and Thickness of SiO₂ Film in Structure of SiO₂ / LN (0°, 110°, 0°) / Sapphire (0°, 122°23', 0°)]

Figs. 30 and 31 are graphs depicting, in the structure of SiO₂ / LN single-crystal plate (0°, 110°, 0°) / R-plane sapphire (0°, 122°23', 0°), the relationship between the thickness of the SiO₂ film and the temperature coefficient of resonance frequency TCF in a free state where the electrode is not formed and the TCF (metallized) in a state where the electrode is formed and the structure has a metallized surface, respectively.

As seen from Fig. 30, when the surface acoustic waves in the first order mode, the second order mode and the third order mode are used, the TCF (free) increases as the thickness of the SiO₂ film increases. Also, as seen from Fig. 31, when the first order mode and the second order mode are used, a value of the TCF (metallized) in the case including the electrode also increases as the thickness of the SiO₂ film increases. When the surface acoustic wave in the third order mode is used, there is a tendency that the TCF (metallized) decreases at the thickness of the SiO₂ film in the range of 0.3λ to 0.4λ as the thickness of the SiO₂ film increases.

Anyway, as seen from Figs. 30 and 31, when the surface acoustic wave in the first order mode is used, the TCF (free) and the TCF (metallized) are both obtained in the range of -30 to +30 ppm/°C by setting the thickness of SiO₂ to the range of 0.12λ to 0.3λ in the free state and 0.18λ to 0.38λ in the metallized state, respectively. Also, by setting the thickness of the SiO₂ film to the range of 0.15λ to 0.28λ in the free state and 0.21λ to 0.33λ in the metallized state, respectively, the TCF (free) and the TCF (metallized) can be both obtained in the range of -20 to +20 ppm/°C; namely, an absolute value of the temperature coefficient of resonance frequency TCF can be reduced. Further, when the surface acoustic wave in the second order mode is used, the temperature coefficient of resonance frequency TCF (free) and the TCF (metallized) can be both obtained in the range of -20 ppm/°C to +10 ppm/°C by setting the thickness of the SiO₂ film to the range of 0.25λ to 0.4λ.

Similarly, when the surface acoustic wave in the third order mode is used, the temperature coefficient of resonance frequency TCF (free) and the TCF (metallized) can be obtained respectively in the range of -18 ppm/°C to -8 ppm/°C and -5 ppm/°C to +5 ppm/°C by setting the thickness of the SiO₂ film to the range of 0.3λ to 0.4λ.

It is hence understood that an absolute value of the temperature coefficient of resonance frequency TCF can be reduced by setting the thickness of the SiO₂ film to any of the above-mentioned ranges.

Additionally, the acoustic velocity in the free state corresponds to an anti-resonant frequency of a surface acoustic wave resonator, and the acoustic velocity in the metallized state corresponds to a resonant frequency.

### [LN (0°, 110°, 0°) / SiO₂ / Sapphire (0°, 122°23', 0°)]

Fig. 32 is a graph depicting, in the surface acoustic wave device 21 illustrated in Fig. 1(c), the relationship between the thickness of the SiO₂ film 5A and the acoustic velocity of a surface acoustic wave. It is here assumed that the thickness of the LN single-crystal plate 3 is 0.15λ and the high acoustic-velocity substrate 2 is made of the R-plane sapphire (0°, 122°23', 0°).

As seen from Fig. 32, the acoustic velocity of the surface acoustic wave in the first order mode is as high as, or higher than, 3900 m/sec over the entire range of 1.6λ or less for the thickness of the SiO₂ film. Also, the acoustic velocity of the surface acoustic wave in the second order mode is as high as, or higher than, 4250 m/sec over the entire range of 1.6λ or less.

It is hence understood that, in the relevant structure, the acoustic velocity of the surface acoustic wave can be effectively increased even when the SiO₂ film is stacked.

Fig. 33 is a graph depicting the relationship between the thickness of the SiO₂ film and the acoustic velocity of a surface acoustic wave in a structure similar to that illustrated in Fig. 32 except that the thickness of the LN single-crystal plate 3 is set to 0.3λ. As seen from Fig. 33, even when the thickness of the LN single-crystal plate 3 is increased to 0.3λ, the acoustic velocity of the surface acoustic wave in the first order mode is as high as, or higher than, 3950 m/sec over the entire range of 1.6λ or less for the thickness of the SiO₂ film. Also, a higher acoustic velocity can be obtained with the surface acoustic waves in the second order mode and the third order mode over the entire range of 1.6λ or less for the thickness of the SiO₂ film.

On the other hand, Figs. 34 to 36 are graphs depicting, in the relevant structure, the relationship among the thickness of the LN single-crystal plate 3, the thickness of the SiO₂ film, and the electromechanical coupling coefficient k². More specifically, Fig. 34 depicts the result obtained for the surface acoustic wave in the first order mode, Fig. 35 depicts the result obtained for the surface acoustic wave in the second order mode, and Fig. 36 depicts the result obtained for the surface acoustic wave in the third order mode.

As seen from Fig. 34, when the thickness of the LN single-crystal plate 3 is any of 0.15λ, 0.2λ, 0.3λ, 0.4λ, 0.5λ and 0.6λ, when the thickness of the SiO₂ film is in excess of 0.15λ, the electromechanical coupling coefficient k² decreases as the thickness of the SiO₂ film increases. Further, when the thickness of the LN single-crystal plate 3 is any of 0.15λ, 0.2λ, 0.3λ, 0.4λ, 0.5λ and 0.6λ, the electromechanical coupling coefficient k² can be obtained as large as 0.1 or more by setting the thickness of the SiO₂ film to 0.65λ or less.

Further, when the thickness of the LN single-crystal plate 3 is 0.2λ or less, the electromechanical coupling coefficient k² can be obtained at 0.07 or more by setting the thickness of the SiO₂ film to 1.4λ or less. More preferably, the electromechanical coupling coefficient k² can be increased to 0.08 or more by setting the thickness of the SiO₂ film to the range of 0.05λ to 1.4λ. Even more preferably, the electromechanical coupling coefficient k² can be increased to 0.13 or more by setting the thickness of the SiO₂ film to the range of 0.25λ to 1.0λ.

In the case using the surface acoustic wave in the second order mode, as seen from Fig. 35, when the thickness of the LN single-crystal plate 3 is set to 0.5λ, the electromechanical coupling coefficient k² can be obtained as large as 0.025 or more at the thickness of the SiO₂ film in the range of 0.35λ to 0.8λ.

In the case using the surface acoustic wave in the third order mode, as seen from Fig. 36, when the thickness of the LN single-crystal plate 3 is any of 0.15λ, 0.2λ, 0.3λ, 0.4λ, 0.5λ and 0.6λ, the electromechanical coupling coefficient k² can be obtained as large as 0.02 or more by setting the thickness of the SiO₂ film to the range of 0.1λ to 1.6λ. Also, the electromechanical coupling coefficient k² of 0.05 or more can be obtained by setting the thickness of the SiO₂ film to the range of 0.2λ to 1.6λ.

It is hence understood that, in the case using the surface acoustic wave in the third order mode in the relevant structure, when the thickness of the LN single-crystal plate 3 is 0.15λ to 0.6λ, the acoustic velocity of the surface acoustic wave and the electromechanical coupling coefficient k² can be both increased by setting the thickness of the SiO₂ film to the range of 0.1λ to 1.6λ.

Figs. 37 and 38 are graphs depicting, when the thickness of the SiO₂ film is set to 0.5λ, 0.8λ or 1.1λ in the relevant structure, the relationship between the thickness of the LN single-crystal plate and the electromechanical coupling coefficient k² for the surface acoustic wave in the first order mode and the second order mode, respectively.

As seen from Fig. 37, when the thickness of the SiO₂ film is any of 0.5λ, 0.8λ and 1.1λ, the electromechanical coupling coefficient k² of 0.02 or more can be obtained when the thickness of the LN single-crystal plate 3 is in the range of 0.04λ to 0.6λ. Also, the electromechanical coupling coefficient k² of 0.06 or more can be obtained by setting the thickness of the SiO₂ film to 0.8λ or less.

Fig. 38 is a graph depicting, when the thickness of the SiO₂ film is set to 0.5λ, 0.8λ or 1.1λ, the relationship between the thickness of the LN single-crystal plate and the electromechanical coupling coefficient k² for the surface acoustic wave in the second order mode. As seen from Fig. 38, when the thickness of the SiO₂ film is any of 0.5λ, 0.8λ and 1.1λ, the electromechanical coupling coefficient can be obtained as a large value when the thickness of the LN single-crystal plate 3 is in the range of 0.04λ to 0.6λ. In particular, at the thickness of the SiO₂ film being 0.8λ and 1.1λ, the electromechanical coupling coefficient k² can be increased to 0.1 or more by setting the thickness of the LN single-crystal plate to be 0.1λ or more and 0.6λ or less.

Fig. 39 is a graph depicting, when the thickness of the LN single-crystal plate is set to 0.15λ and the surface acoustic waves in the first order mode and the second order mode are used in the structure of LN (0°, 110°, 0°) / SiO₂ / R-plane Sapphire (0°, 122°23', 0°), the relationship between the thickness of the SiO₂ film and the temperature coefficient of resonance frequency TCF.

As seen from Fig. 39, when the surface acoustic wave in the first order mode is used, the TCF (free) can be obtained in the range of -30 ppm/°C to +30 ppm/°C by setting the thickness of the SiO₂ film to the range of 0.07λ to 0.72λ, and the TCF (metallized) can be obtained in the range of -30 ppm/°C to +30 ppm/°C by setting the thickness of the SiO₂ film to the range of 0.25λ to 1.4λ.

Similarly, when the surface acoustic wave in the second order mode is used, the TCF (free) and the TCF (metallized) can be obtained respectively in the range of +20 ppm/°C to +33 ppm/°C and +33 ppm/°C to +43 ppm/°C by setting the thickness of the SiO₂ film to the range of 0.6λ to 1.4λ.

On the other hand, Fig. 40 is a graph depicting, when the thickness of the LN single-crystal plate 3 is set to 0.3λ in the structure of LN (0°, 110°, 0°) / SiO₂ / R-plane Sapphire (0°, 122°23', 0°), the relationship between the thickness of the SiO₂ film and the TCF (free) for the surface acoustic waves in the first order mode, the second order mode and the third order mode. Fig. 41 depicts the relationship between the thickness of the SiO₂ film and the TCF (metallized).

As seen from Figs. 40 and 41, when the surface acoustic wave in the first order mode is used, the TCF (free) can be preferably held in the range of -30 ppm/°C to +30 ppm/°C by setting the thickness of the SiO₂ film to the range of 0.27λ to 0.7λ. More preferably, the TCF (metallized) can be obtained in the range of +30 ppm/°C to -30 ppm/°C by setting the thickness of the SiO₂ film to the range of 0.67λ to 1.6λ. Further, by setting the thickness of the SiO₂ film to the range of 0.37λ to 0.65λ and 0.85λ to 1.47λ, respectively, the TCF (free) and the TCF (metallized) can be both obtained in the range of -20 to +20 ppm/°C.

Similarly, when the surface acoustic wave in the second order mode is used, the TCF (free) can be obtained in the range of -30 ppm/°C to +30 ppm/°C and the TCF (metallized) can be obtained in the range of -33 ppm/°C to +33 ppm/°C preferably by setting the thickness of the SiO₂ film to the range of 0.3λ to 0.7λ. More preferably, the TCF (free) can be obtained in the range of -20 ppm/°C to +7 ppm/°C and the TCF (metallized) can be obtained in the range of -20 ppm/°C to +20 ppm/°C by setting the thickness of the SiO₂ film to the range of 0.38λ to 0.6λ.

Similarly, when the surface acoustic wave in the third order mode is used, the TCF (free) can be obtained in the range of +30 ppm/°C to 0 ppm/°C and the TCF (metallized) can be obtained in the range of +12 ppm/°C to +25 ppm/°C preferably by setting the thickness of the SiO₂ film to the range of 0.4λ to 1.35λ. More preferably, the TCF (free) can be obtained in the range of +20 to 0 ppm/°C by setting the thickness of SiO₂ to the range of 0.4λ to 1.17λ.

### [Structure where High Acoustic-Velocity Substrate is Si Substrate Having Euler Angles (90°, 90°, 45°)]

Fig. 42 is a graph depicting, in a structure of the surface acoustic wave device 21 according to the third embodiment, illustrated in Fig. 1(c), where the high acoustic-velocity substrate 2 is made of Si (90°, 90°, 45°) and the Euler angles of the LN single-crystal plate are (0°, 110°, 0°), the relationship between the thickness of the SiO₂ film and the acoustic velocity of a surface acoustic wave in the first order mode in the free structure and the metallized structure when the thickness of the LN single-crystal plate is set to 0.1λ, 0.2λ, 0.3λ, 0.4λ or 0.5λ.

When the thickness of the LN single-crystal plate is any of 0.1λ, 0.2λ, 0.3λ, 0.4λ and 0.5λ, as seen from Fig. 42, the acoustic velocity of the surface acoustic wave (free) can be obtained as high as, or higher than, 3900 m/sec by setting the thickness of the SiO₂ film to the range of 0.05λ to 1.4λ.

Fig. 43 is a graph depicting, in the structure of the surface acoustic wave device 21 according to the third embodiment, illustrated in Fig. 1(c), where the high acoustic-velocity substrate 2 is made of Si (90°, 90°, 45°) and the Euler angles of the LN single-crystal plate are (0°, 110°, 0°), the relationship between the thickness of the SiO₂ film and the acoustic velocity of a surface acoustic wave in the second order mode in the free structure and the metallized structure when the thickness of the LN single-crystal plate is set to 0.1λ, 0.2λ, 0.3λ, 0.4λ or 0.5λ.

When the thickness of the LN single-crystal plate is any of 0.1λ, 0.2λ, 0.3λ, 0.4λ and 0.5λ, as seen from Fig. 43, the acoustic velocity of the surface acoustic wave (free) can be obtained as high as, or higher than, 4230 m/sec by setting the thickness of the SiO₂ film to the range of 0.7λ to 1.4λ.

Fig. 44 is a graph depicting, when the surface acoustic wave in the first order mode and the surface acoustic wave in the second order mode are used in the relevant structure, the relationship between the thickness of the SiO₂ film and the electromechanical coupling coefficient k².

As seen from Fig. 44, when the surface acoustic wave in the first order mode is used, the electromechanical coupling coefficient of 0.02 or more can be obtained by setting the thickness of the SiO₂ film to the range of 0.05λ to 1.1λ when the thickness of the LN single-crystal plate is 0.1λ, 0.2λ, 0.3λ, 0.4λ or 0.5λ. When the surface acoustic wave in the second order mode is used, the electromechanical coupling coefficient of 0.06 or more can be obtained by setting the thickness of the SiO₂ film to the range of 0.7λ to 1.4λ when the thickness of the LN single-crystal plate is 0.1λ. 0.2λ, 0.3λ, 0.4λ or 0.5λ.

Fig. 45 is a graph depicting, when the thickness of the LN single-crystal plate is set to 0.1λ, 0.2λ, 0.3λ, 0.4λ or 0.5λ in the relevant structure, the relationship between the temperature coefficient of resonance frequency TCF and the thickness of the SiO₂ film for the surface acoustic wave in the first order mode.

When the thickness of the LN single-crystal plate is any of 0.1λ, 0.2λ, 0.3λ, 0.4λ, and 0.5λ, as seen from Fig. 45, the TCF (free) can be obtained in the range of -27 ppm/°C to +30 ppm/°C by setting the thickness of the SiO₂ film to the range of 0.05λ to 0.65λ, and the TCF (metallized) can be obtained in the range of - 30 ppm/°C to +30 ppm/°C by setting the thickness of SiO₂ to the range of 0.33λ to 1.4λ. The TCF in the range of -20 to +20 ppm/°C can be obtained by setting the thickness of SiO₂ to the range of 0.1λ to 0.4λ in the free structure and the range of 0.1λ to 1.4λ in the metallized structure.

Fig. 46 is a graph depicting, when the thickness of the LN single-crystal plate is set to 0.1λ, 0.2λ, 0.3λ, 0.4λ or 0.5λ in the relevant structure, the relationship between the temperature coefficient of resonance frequency TCF and the thickness of the SiO₂ film for the surface acoustic wave in the second order mode.
when the thickness of the LN single-crystal plate is any of 0.1λ, 0.2λ, 0.3λ, 0.4λ and 0.5λ, as seen from Fig. 46, the TCF (free) can be obtained in the range of -30 ppm/°C to +30 ppm/°C and the TCF (metallized) can be obtained in the range of -33 ppm/°C to +48 ppm/°C by setting the thickness of the SiO₂ film to the range of 0.6λ to 1.3λ.

### [LN (0°, 110°, 0°) / SiO₂ / Si (135°, 90°, 90°)]

Fig. 47 is a graph depicting, in a structure of the third embodiment, illustrated in Fig. 1(c), where the high acoustic-velocity substrate 2 is made of Si (135°, 90°, 90°) and the Euler angles of the LN single-crystal plate are (0°, 110°, 0°), the relationship between the thickness of the SiO₂ film and the acoustic velocity of a surface acoustic wave in the first order mode in the free structure and the metallized structure when the thickness of the LN single-crystal plate is set to 0.1λ, 0.2λ, 0.3λ, 0.4λ or 0.5λ.

When the thickness of the LN single-crystal plate is any of 0.1λ, 0.2λ, 0.3λ, 0.4λ and 0.5λ, as seen from Fig. 47, the acoustic velocity of the surface acoustic wave (free) is 3930 m/sec or higher with a small reduction even when the thickness of the SiO₂ film is in the range of 0.05λ to 1.4λ.

Fig. 48 is a graph depicting, when the surface acoustic wave in the first order mode is used in the relevant structure, the relationship between the thickness of the SiO₂ film and the electromechanical coupling coefficient k².

As seen from Fig. 48, when the surface acoustic wave in the first order mode is used, the electromechanical coupling coefficient of 0.05 or more can be obtained by setting the thickness of the SiO₂ film to the range of 0.05λ to 0.83λ when the thickness of the LN single-crystal plate is any of 0.1λ, 0.2λ, 0.3λ, 0.4λ and 0.5λ.

Fig. 49 is a graph depicting, when the thickness of the LN single-crystal plate is set to 0.1λ, 0.2λ, 0.3λ, 0.4λ or 0.5λ in the relevant structure, the relationship between the temperature coefficient of resonance frequency TCF and the thickness of the SiO₂ film for the surface acoustic wave in the first order mode.

When At the thickness of the LN single-crystal plate is any of 0.1λ, 0.2λ, 0.3λ, 0.4λ and 0.5λ, as seen from Fig. 49, the TCF (free) can be preferably obtained in the range of -30 ppm/°C to +30 ppm/°C by setting the thickness of the SiO₂ film to the range of 0.05λ to 0.65λ, and the TCF (metallized) can be preferably obtained in the range of -30 ppm/°C to +30 ppm/°C by setting the thickness of SiO₂ to the range of 0.33λ to 1.4λ. Further, the TCF in the range of -20 to +20 ppm/°C can be obtained by setting the thickness of SiO₂ to the range of 0.07λ to 0.6λ in the free structure and the range of 0.22λ to 1.4λ in the metallized structure.

### [LN (0°, 110°, 0°) / SiO₂ / Polycrystalline Si]

Fig. 58 is a graph depicting, in a structure of the third embodiment, illustrated in Fig. 1(c), where the high acoustic-velocity substrate 2 is made of polycrystalline Si and the Euler angles of the LN single-crystal plate are (0°, 110°, 0°), the relationship between the thickness of the SiO₂ film and the acoustic velocity of a surface acoustic wave in the first order mode in the free structure and the metallized structure when the thickness of the LN single-crystal plate is set to 0.1λ, 0.2λ, 0.3λ, 0.4λ, or 0.5λ.

When the thickness of the LN single-crystal plate is any of 0.1λ, 0.2λ, 0.3λ, 0.4λ, and 0.5λ, as seen from Fig. 58, the acoustic velocity of the surface acoustic wave (free) is 3940 m/sec or higher with a small reduction even when the thickness of the SiO₂ film is in the range of 0.05λ to 1.4λ.

Fig. 59 is a graph depicting, when the surface acoustic wave in the first order mode is used in the relevant structure, the relationship between the thickness of the SiO₂ film and the electromechanical coupling coefficient k².

As seen from Fig. 59, when the surface acoustic wave in the first order mode is used, the electromechanical coupling coefficient of 0.02 or more can be obtained by setting the thickness of the SiO₂ film to the range of 0.05λ to 1.1λ when the thickness of the LN single-crystal plate is any of 0.1λ, 0.2λ, 0.3λ, 0.4λ, and 0.5λ.

### [LN (90°, θ, 0°) / R-Plane Sapphire (0°, 122°23', 0°)]

Fig. 52 is a graph depicting, when the high acoustic-velocity substrate 2 is a substrate made of R-plane sapphire having the Euler angles (0°, 122°23', 0°), the Euler angles of the LN single-crystal plate 3 are (90°, θ, 0°), and the thickness of the LN single-crystal plate 3 is set to 0.3λ in the surface acoustic wave device related to the first embodiment, the relationship between the Euler angle θ and the acoustic velocity of a surface acoustic wave. Fig. 53 depicts the relationship between the Euler angle θ and the electromechanical coupling coefficient k² in the same case.

As seen from Fig. 52, the acoustic velocity of the surface acoustic wave in the first order mode is 4700 m/sec and is much higher than that of the Rayleigh wave at θ over the entire range of 40° to 160°. Particularly, the acoustic velocity is further increased to 5000 m/sec or higher when the Euler angle θ is in the range of 47° to 127°.

On the other hand, as seen from Fig. 53, the electromechanical coupling coefficient k² is as large as, or larger than, 0.1 at the Euler angle θ in the range of 53° to 123°. More preferably, the electromechanical coupling coefficient k² is increased to 0.15 or more in the range of 60° to 115°. Even more preferably, the electromechanical coupling coefficient of 0.22 or more can be obtained in the range of 84° to 88°.

Fig. 60 is a graph depicting, when the high acoustic-velocity substrate 2 is a substrate made of SiC (0°, 0°, 0°), alumina, aluminum nitride, silicon nitride, Si (135°, 90°, 90°) or a Si polycrystal, the Euler angles of the LN single-crystal plate 3 are (90°, θ, 0°), and the thickness of the LN single-crystal plate 3 is set to 0.3λ in the surface acoustic wave device related to the first embodiment, the relationship between the Euler angle θ and the electromechanical coupling coefficient k².

As seen from Fig. 60, when the high acoustic-velocity substrate 2 is made of SiC (0°, 0°, 0°), the electromechanical coupling coefficient k² is preferably as large as, or larger than, 0.12 at the Euler angle θ in the range of 54° to 133°. More preferably, the electromechanical coupling coefficient of 0.23 or more is obtained in the range of 81° to 88°.

When the high acoustic-velocity substrate 2 is made of alumina, the electromechanical coupling coefficient k² is preferably as large as, or larger than, 0.12 when the Euler angle θ is in the range of 54° to 117°. More preferably, the electromechanical coupling coefficient of 0.119 or more is obtained in the range of 83° to 88°. Also, when the high acoustic-velocity substrate 2 is made of aluminum nitride, the electromechanical coupling coefficient k² is as large as, or larger than, 0.12 when the Euler angle θ is in the range of 52° to 122°. More preferably, the electromechanical coupling coefficient of 0.21 or more is obtained in the range of 81° to 88°.

When the high acoustic-velocity substrate 2 is made of silicon nitride, the electromechanical coupling coefficient k² is preferably as large as, or larger than, 0.12 when the Euler angle θ is in the range of 54° to 120°. More preferably, the electromechanical coupling coefficient of 0.215 or more is obtained in the range of 81° to 87°.

When the high acoustic-velocity substrate 2 is made of Si (135°, 90°, 90°), the electromechanical coupling coefficient k² is preferably as large as, or larger than, 0.12 when the Euler angle θ is in the range of 51° to 118°. More preferably, the electromechanical coupling coefficient of 0.21 or more is obtained in the range of 80° to 88°.

When the high acoustic-velocity substrate 2 is made of a Si polycrystal, the electromechanical coupling coefficient k² is preferably as large as, or larger than, 0.12 when the Euler angle θ is in the range of 52° to 118°. More preferably, the electromechanical coupling coefficient of 0.185 or more is obtained in the range of 82° to 88°.

Thus, the electromechanical coupling coefficient can be obtained as large values.

It is to be noted that, while the foregoing description is made in connection with the case where ψ of the Euler angles of LiNbO₃ and the high acoustic-velocity substrate, i.e., the propagation orientation, is 0°, almost the same behaviors as those in the case of 0° are obtained insofar as the propagation orientation ψ is in the range of -5° to +5°.

### Reference Signs List

- 1, 11, 21: surface acoustic wave device
- 2: high acoustic-velocity substrate
- 3: LiNbO₃ single-crystal plate
- 4: electrode
- 5, 5A: SiO₂ film

## Claims

1. A surface acoustic wave device (1/11/21) comprising:
a piezoelectric substrate including a high acoustic-velocity substrate (2) in which an acoustic velocity of a transverse wave is 5400 m/sec or higher and 8660 m/sec or lower, and
a LiNbO₃ single-crystal plate (3) formed on the high acoustic-velocity substrate and having Euler angles (0°, 67° to 160°, -5° to +5°); and
an electrode (4) formed on the piezoelectric substrate and made of metal;
**characterized in that** the thickness of the LiNbO₃ single-crystal plate (3) is in a range of 0.05λ to 1.6λ when a wavelength of a surface acoustic wave is defined as λ.

2. The surface acoustic wave device according to Claim 1, wherein the high acoustic-velocity substrate (2) is a substrate made of a material selected from a group consisting of silicon carbide, alumina, aluminum nitride, sapphire, silicon nitride, silicon, and magnesium oxide.

3. The surface acoustic wave device according to Claim 1 or 2, wherein the Euler angles are in a range of (0°, 92° to 132°, -5° to +5°).

4. The surface acoustic wave device according to any of Claims 1 to 3, wherein the surface acoustic wave is a first order wave.

5. The surface acoustic wave device according to Claim 1 or 2, wherein the high acoustic-velocity substrate (2) is made of SiC, and the Euler angles of the LiNbO₃ single-crystal plate (3) are in a range of (0°, 70° to 160°, -5° to +5°).

6. The surface acoustic wave device according to Claim 1 or 2, wherein the high acoustic-velocity substrate (2) is made of alumina, and the Euler angles of the LiNbO₃ single-crystal plate (3) are in a range of (0°, 70° to 160°, -5° to +5°).

7. The surface acoustic wave device according to Claim 1 or 2, wherein the high acoustic-velocity substrate (2) is made of aluminum nitride, and the Euler angles of the LiNbO₃ single-crystal plate (3) are in a range of (0°, 70° to 153°, -5° to +5°).

8. The surface acoustic wave device according to Claim 1 or 2, wherein the high acoustic-velocity substrate (2) is made of sapphire, and the Euler angles of the LiNbO₃ single-crystal plate (3) are in a range of (0°, 67° to 147°, -5° to +5°).

9. The surface acoustic wave device according to Claim 1 or 2, wherein the high acoustic-velocity substrate (2) is made of silicon nitride, and the Euler angles of the LiNbO₃ single-crystal plate (3) are in a range of (0°, 70° to 153°, -5° to +5°).

10. The surface acoustic wave device according to Claim 1 or 2, wherein the high acoustic-velocity substrate (2) is made of silicon.

11. The surface acoustic wave device according to Claim 10, wherein the silicon is made of a silicon single-crystal, and the Euler angles of the LiNbO₃ single-crystal plate (3) are in a range of (0°, 75° to 152°, -5° to +5°).

12. The surface acoustic wave device according to Claim 10, wherein the silicon is made of a silicon polycrystal, and the Euler angles of the LiNbO₃ single-crystal plate (3) are in a range of (0°, 75° to 148°, -5° to +5°).

13. The surface acoustic wave device (11) according to any of Claims 1 to 12, further comprising a silicon oxide film (5) formed on the LiNbO₃ single-crystal plate (3), the silicon oxide film (5) having a thickness in a range of 0.1λ to 0.4λ.

14. The surface acoustic wave device (21) according to any of Claims 1 to 13, further comprising a silicon oxide film (5A) formed between the high acoustic-velocity substrate (2) and the LiNbO₃ single-crystal plate (3), the silicon oxide film (5A) having a thickness in a range of 0.05λ to 1.4λ.

## Patentansprüche

1. Oberflächenschallwellenvorrichtung (1/11/21), umfassend:
ein piezoelektrisches Substrat, das ein Substrat (2) mit hoher Schallgeschwindigkeit beinhaltet, bei dem eine Schallgeschwindigkeit einer Transversalwelle 5400 m/s oder mehr, und 8660 m/s oder weniger beträgt, und
eine LiNbO₃-Einkristallplatte (3), die auf dem Substrat mit hoher Schallgeschwindigkeit ausgebildet ist und Euler-Winkel (0°, 67° bis 160°, -5° bis +5°) aufweist, und
eine Elektrode (4), die auf dem piezoelektrischen Substrat ausgebildet ist und aus Metall besteht,
**dadurch gekennzeichnet, dass** die Dicke der LiNbO₃-Einkristallplatte (3) in einem Bereich von 0,05 λ bis 1,6 A liegt, wenn eine Wellenlänge einer akustischen Oberflächenwelle als λ definiert ist.

2. Oberflächenschallwellenvorrichtung nach Anspruch 1, wobei das Substrat (2) mit hoher Schallgeschwindigkeit ein Substrat ist, das aus einem Material besteht, das aus einer Gruppe bestehend aus Siliciumcarbid, Aluminiumoxid, Aluminiumnitrid, Saphir, Siliciumnitrid, Silicium und Magnesiumoxid ausgewählt ist.

3. Oberflächenschallwellenvorrichtung nach Anspruch 1 oder 2, wobei die Euler-Winkel in einem Bereich von (0°, 92° bis 132°, -5° bis +5°) liegen.

4. Oberflächenschallwellenvorrichtung nach einem der Ansprüche 1 bis 3, wobei die Oberflächenschallwelle eine Welle erster Ordnung ist.

5. Oberflächenschallwellenvorrichtung nach Anspruch 1 oder 2, wobei das Substrat (2) mit hoher Schallgeschwindigkeit aus SiC besteht und die Euler-Winkel der LiNbO₃-Einkristallplatte (3) in einem Bereich von (0°, 70° bis 160°, -5° bis +5°) liegen.

6. Oberflächenschallwellenvorrichtung nach Anspruch 1 oder 2, wobei das Substrat (2) mit hoher Schallgeschwindigkeit aus Aluminiumoxid besteht und die Euler-Winkel der LiNbO₃-Einkristallplatte (3) in einem Bereich von (0°, 70° bis 160°, -5° bis +5°) liegen.

7. Oberflächenschallwellenvorrichtung nach Anspruch 1 oder 2, wobei das Substrat (2) mit hoher Schallgeschwindigkeit aus Aluminiumnitrid besteht und die Euler-Winkel der LiNbO₃-Einkristallplatte (3) in einem Bereich von (0°, 70° bis 153°, -5° bis +5°) liegen.

8. Oberflächenschallwellenvorrichtung nach Anspruch 1 oder 2, wobei das Substrat (2) mit hoher Schallgeschwindigkeit aus Korund besteht und die Euler-Winkel der LiNbO₃-Einkristallplatte (3) in einem Bereich von (0°, 67° bis 147°, -5° bis +5°) liegen.

9. Oberflächenschallwellenvorrichtung nach Anspruch 1 oder 2, wobei das Substrat (2) mit hoher Schallgeschwindigkeit aus Siliciumnitrid besteht und die Euler-Winkel der LiNbO₃-Einkristallplatte (3) in einem Bereich von (0°, 70° bis 153°, -5° bis +5°) liegen.

10. Oberflächenschallwellenvorrichtung nach Anspruch 1 oder 2, wobei das Substrat (2) mit hoher Schallgeschwindigkeit aus Silicium besteht.

11. Oberflächenschallwellenvorrichtung nach Anspruch 10, wobei das Silicium aus einem Silicium-Einkristall besteht und die Euler-Winkel der LiNbO₃-Einkristallplatte (3) in einem Bereich von (0°, 75° bis 152°, -5° bis +5°) liegen.

12. Oberflächenschallwellenvorrichtung nach Anspruch 10, wobei das Silicium aus einem Silicium-Polykristall besteht und die Euler-Winkel der LiNbO₃-Einkristallplatte (3) in einem Bereich von (0°, 75° bis 148°, -5° bis +5°) liegen.

13. Oberflächenschallwellenvorrichtung (11) nach einem der Ansprüche 1 bis 12, ferner umfassend einen Siliciumoxidfilm (5), der auf der LiNbO₃-Einkristallplatte (3) ausgebildet ist, wobei der Siliciumoxidfilm (5) eine Dicke in einem Bereich von 0,1 λ bis 0,4 λ aufweist.

14. Oberflächenschallwellenvorrichtung (21) nach einem der Ansprüche 1 bis 13, ferner umfassend einen Siliciumoxidfilm (5A), der zwischen dem Substrat (2) mit hoher Schallgeschwindigkeit und der LiNbO₃-Einkristallplatte (3) ausgebildet ist, wobei der Siliciumoxidfilm (5A) eine Dicke in einem Bereich von 0,05 λ bis 1,4 λ aufweist.

## Revendications

1. Dispositif à ondes élastiques de surface (1/11/21) comprenant :
un substrat piézoélectrique comprenant un substrat à vitesse acoustique élevée (2) dans lequel une vitesse acoustique d'une onde transversale est de 5400 m/sec ou plus et de 8660 m/sec ou moins, et
une plaque en monocristal de LiNbO₃ (3) formée sur le substrat à vitesse acoustique élevée et ayant des angles de Euler de (0°, 67 à 160°, -5 à +5°) ; et
une électrode (4) formée sur le substrat piézoélectrique et à base de métal ;
**caractérisé en ce que** l'épaisseur de la plaque en monocristal de LiNbO₃ (3) est dans une plage de 0,05 à 1,6 λ quand une longueur d'onde d'une onde élastique de surface est définie à λ.

2. Dispositif à ondes élastiques de surface selon la revendication 1, dans lequel le substrat à vitesse acoustique élevée (2) est un substrat à base d'un matériau choisi dans le groupe constitué par le carbure de silicium, l'alumine, le nitrure d'aluminium, le saphir, le nitrure de silicium, le silicium, et l'oxyde de magnésium.

3. Dispositif à ondes élastiques de surface selon la revendication 1 ou 2, dans lequel les angles de Euler sont dans une plage de (0°, 92 à 132°, -5 à +5°).

4. Dispositif à ondes élastiques de surface selon l'une quelconque des revendications 1 à 3, dans lequel l'onde élastique de surface est une onde de premier ordre.

5. Dispositif à ondes élastiques de surface selon la revendication 1 ou 2, dans lequel le substrat à vitesse acoustique élevée (2) est à base de SiC, et les angles de Euler de la plaque en monocristal de LiNbO₃ (3) sont dans une plage de (0°, 70 à 160°, -5 à +5°).

6. Dispositif à ondes élastiques de surface selon la revendication 1 ou 2, dans lequel le substrat à vitesse acoustique élevée (2) est à base d'alumine, et les angles de Euler de la plaque en monocristal de LiNbO₃ (3) sont dans une plage de (0°, 70 à 160°, -5 à +5°).

7. Dispositif à ondes élastiques de surface selon la revendication 1 ou 2, dans lequel le substrat à vitesse acoustique élevée (2) est à base de nitrure d'aluminium, et les angles de Euler de la plaque en monocristal de LiNbO₃ (3) sont dans une plage de (0°, 70 à 153°, -5 à +5°).

8. Dispositif à ondes élastiques de surface selon la revendication 1 ou 2, dans lequel le substrat à vitesse acoustique élevée (2) est à base de saphir, et les angles de Euler de la plaque en monocristal de LiNbO₃ (3) sont dans une plage de (0°, 67 à 147°, -5 à +5°).

9. Dispositif à ondes élastiques de surface selon la revendication 1 ou 2, dans lequel le substrat à vitesse acoustique élevée (2) est à base de nitrure de silicium, et les angles de Euler de la plaque en monocristal de LiNbO₃ (3) sont dans une plage de (0°, 70 à 153°, -5 à +5°).

10. Dispositif à ondes élastiques de surface selon la revendication 1 ou 2, dans lequel le substrat à vitesse acoustique élevée (2) est à base de silicium.

11. Dispositif à ondes élastiques de surface selon la revendication 10, dans lequel le silicium est sous la forme d'un monocristal de silicium, et les angles de Euler de la plaque en monocristal de LiNbO₃ (3) sont dans une plage de (0°, 75 à 152°, -5 à +5°).

12. Dispositif à ondes élastiques de surface selon la revendication 10, dans lequel le silicium est sous la forme d'un polycristal de silicium, et les angles de Euler de la plaque en monocristal de LiNbO₃ (3) sont dans une plage de (0°, 75 à 148°, -5 à +5°).

13. Dispositif à ondes élastiques de surface (11) selon l'une quelconque des revendications 1 à 12, comprenant en outre un film d'oxyde de silicium (5) formé sur la plaque en monocristal de LiNbO₃ (3), le film d'oxyde de silicium (5) ayant une épaisseur dans la plage de 0,1 à 0,4 λ.

14. Dispositif à ondes élastiques de surface (21) selon l'une quelconque des revendications 1 à 13, comprenant en outre un film d'oxyde de silicium (5A) formé entre le substrat à vitesse acoustique élevée (2) et la plaque en monocristal de LiNbO₃ (3), le film d'oxyde de silicium (5A) ayant une épaisseur dans une plage de 0,05 à 1,4 λ.
